(19) **Europäisches Patentamt**
**European Patent Office**
**Office européen des brevets**

(11) **EP 4 683 217 A1**

(12) **EUROPEAN PATENT APPLICATION**
published in accordance with Art. 153(4) EPC

(43) Date of publication:
**21.01.2026 Bulletin 2026/04**

(21) Application number: **24802623.9**

(22) Date of filing: **22.03.2024**

(51) International Patent Classification (IPC):
***H03F 3/189*** (2006.01)     ***H03F 1/26*** (2006.01)

(52) Cooperative Patent Classification (CPC):
**H03F 1/26; H03F 3/189**

(86) International application number:
**PCT/CN2024/083224**

(87) International publication number:
**WO 2024/230335 (14.11.2024 Gazette 2024/46)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **08.05.2023 CN 202310512887**

(71) Applicant: **Honor Device Co., Ltd.**
**Shenzhen, Guangdong 518040 (CN)**

(72) Inventors:
• **HUANG, Qinghua**
**Shenzhen, Guangdong 518040 (CN)**
• **LIU, Pan**
**Shenzhen, Guangdong 518040 (CN)**
• **SUN, Jiangtao**
**Shenzhen, Guangdong 518040 (CN)**
• **MEI, Zheng**
**Shenzhen, Guangdong 518040 (CN)**
• **MA, Jianfu**
**Shenzhen, Guangdong 518040 (CN)**

(74) Representative: **Gill Jennings & Every LLP**
**The Broadgate Tower**
**20 Primrose Street**
**London EC2A 2ES (GB)**

(54) **RADIO FREQUENCY MODULE, LOW-NOISE AMPLIFIER AND ELECTRONIC DEVICE**

(57)     A radio frequency module, a low-noise amplifier, and an electronic device. The radio frequency module includes: N first low-noise amplifiers coupled between a signal input port and a signal output port, where an input impedance and an output impedance of the first low-noise amplifier match a first frequency band; and M second low-noise amplifiers coupled between the signal input port and the signal output port, where the second low-noise amplifier includes an impedance adjustment network, and the impedance adjustment network can adjust an input impedance and an output impedance of the second low-noise amplifier, so that the input impedance and the output impedance of the second low-noise amplifier match different frequency bands. In this way, the second low-noise amplifier can be reused between different frequency bands such as an LB band and an MHB band, thereby increasing utilization of the low-noise amplifier, so that when a maximum use scenario of the radio frequency module is unchanged, a quantity of required low-noise amplifiers is smaller, and a chip area is smaller.

FIG. 13

## Description

This application claims priority to Chinese Patent Application No. 202310512887.1, filed with the China National Intellectual Property Administration on May 8, 2023 and entitled "RADIO FREQUENCY MODULE, LOW-NOISE AMPLIFIER, AND ELECTRONIC DEVICE", which is incorporated herein by reference in its entirety.

## TECHNICAL FIELD

This application relates to the field of communication technologies, and in particular, to a radio frequency module, a low-noise amplifier, and an electronic device.

## BACKGROUND

A radio frequency module is an integrated circuit that can receive and transmit a radio frequency signal and process the radio frequency signal. A main function of the radio frequency module is to perform up-conversion and filtering on a baseband signal to obtain a radio frequency signal and transmit the radio frequency signal, and perform down-conversion and filtering on a received radio frequency signal to obtain a baseband signal.

To meet a communication scenario of a middle band and a high band (Middle Band and High Band, MHB) and a low band (Low Band, LB), the radio frequency module may include one or more low-noise amplifiers (low-noise amplifier, LNA) that may operate in the middle band MB and the high band HB, and one or more LNAs that may operate in the LB. Because an interval between the LB and the MHB is relatively long, a conventional LNA of the MHB cannot cover a bandwidth of the LB, and therefore cannot be used as an LNA of the LB. Similarly, a conventional LNA of the LB cannot cover a bandwidth of the MHB band, and cannot be used as an LNA of the MHB.

Therefore, in actual use, when the radio frequency module operates in the MHB scenario, the LNA of the LB is idle, and when the radio frequency module operates in the LB scenario, the LNA of the MHB is idle, thereby reducing utilization of the LNA, causing a waste of LNA resources, and increasing costs. In addition, each LNA occupies a part of space in the radio frequency module. Therefore, when the radio frequency module is designed according to a maximum requirement in each use scenario, a quantity of LNAs is large, which results in a large size of the radio frequency module which is difficult to be applied to a small-sized electronic device such as a mobile phone.

## SUMMARY

To resolve the foregoing technical problem, embodiments of this application provide a radio frequency module, a low-noise amplifier, and an electronic device.

According to a first aspect, an embodiment of this application provides a radio frequency module, including: N first low-noise amplifiers coupled between a signal input port and a signal output port, where N is a positive integer, and an input impedance and an output impedance of the first low-noise amplifier match a first frequency band; and M second low-noise amplifiers coupled between the signal input port and the signal output port, where M is a positive integer; where the second low-noise amplifier is configured as a first impedance state, and the first impedance state includes: an input impedance and an output impedance of the second low-noise amplifier match a second frequency band, where the second frequency band is lower than the first frequency band; and the second low-noise amplifier includes a first impedance adjustment network, the first impedance adjustment network is configured to adjust the input impedance and the output impedance of the second low-noise amplifier, so that the second low-noise amplifier is switched from the first impedance state to a second impedance state, where the second impedance state includes: the input impedance and the output impedance of the second low-noise amplifier match the first frequency band.

According to the radio frequency module provided in this embodiment of this application, the impedance adjustment network is added to the second low-noise amplifier, and the input impedance and the output impedance of the second low-noise amplifier may be adjusted by using the impedance adjustment network, so that the second low-noise amplifier can be switched between different impedance states, so as to match different frequency bands. In this way, the second low-noise amplifier may be used as a low-noise amplifier in the second frequency band, and may be reused as a low-noise amplifier in the first frequency band, thereby increasing utilization of the low-noise amplifier. In a case in which a maximum use scenario is unchanged, the radio frequency module requires a smaller quantity of low-noise amplifiers, and a chip area is smaller.

In an implementation, the first frequency band is a middle band MB and/or a high band HB, and the second frequency band is a low band LB; or the first frequency band is a high band HB, and the first frequency band is a middle band MB. In this way, the second low-noise amplifier may be used as a low-noise amplifier of the LB, and may be reused as a low-noise amplifier of the MHB.

In an implementation, the radio frequency module further includes: a first switch matrix, where the first switch matrix includes A input terminals and at least one output terminal, A is a positive integer, and A=M+N; where N input terminals of the first switch matrix are coupled to output terminals of the N first low-noise amplifiers in a one-to-one correspondence; and the at least one output terminal of the first switch matrix is coupled to at least one first output port in a one-to-one correspondence, and the first output port is a signal output port of the first frequency band. In this way, the radio frequency signal output by the first low-noise amplifier may be output to the outside through the first switch matrix.

In an implementation, M input terminals of the first switch matrix are in a one-to-one correspondence with output terminals of the M second low-noise amplifiers; and when the second low-noise amplifier is switched to the second impedance state, an output terminal of the second low-noise amplifier is coupled to an input terminal of the first switch matrix corresponding thereto. In this way, when the second low-noise amplifier is switched to the second impedance state, the radio frequency signal that is of the first frequency band and that is output by the second low-noise amplifier may be output to the outside through the first switch matrix.

In an implementation, when the second low-noise amplifier is switched to the first impedance state, the second low-noise amplifier is coupled to one or more second output ports, and the second output port is a signal output port of the second frequency band. In this way, when the second low-noise amplifier is switched to the first impedance state, the radio frequency signal that is of the second frequency band and that is output by the second low-noise amplifier may be output to the outside through the signal output port of the second frequency band.

In an implementation, the radio frequency module further includes: L third low-noise amplifiers coupled between the signal input port and the signal output port, where L is a positive integer; where an input impedance and an output impedance of the third low-noise amplifier match the second frequency band. In this way, when the second low-noise amplifier is switched to the first impedance state, the second low-noise amplifier and the third low-noise amplifier may cooperate to meet a MIMO or CA receiving requirement.

In an implementation, the radio frequency module further includes: a second switch matrix, where the second switch matrix includes B input terminals and at least one output terminal, B is a positive integer, and B=M+L; where L input terminals of the second switch matrix are coupled to output terminals of the L third low-noise amplifiers in a one-to-one correspondence; and the at least one output terminal of the second switch matrix is coupled to at least one second output port in a one-to-one correspondence, and the second output port is a signal output port of the second frequency band. In this way, the radio frequency signal output by the third low-noise amplifier may be output to the outside through the second switch matrix.

In an implementation, M input terminals of the second switch matrix are in a one-to-one correspondence with the output terminals of the M second low-noise amplifiers; and when the second low-noise amplifier is switched to the first impedance state, the second low-noise amplifier is coupled to an input terminal of the second switch matrix corresponding thereto. In this way, when the second low-noise amplifier is switched to the first impedance state, the radio frequency signal that is of the second frequency band and that is output by the second low-noise amplifier may be output to the outside through the second switch matrix.

In an implementation, the radio frequency module further includes: K fourth low-noise amplifiers coupled between the signal input port and the signal output port, where K is a positive integer; where the fourth low-noise amplifier is configured as the second impedance state; and the fourth low-noise amplifier includes a second impedance adjustment network, and the second impedance adjustment network is configured to adjust an input impedance and/or an output impedance of the fourth low-noise amplifier, so that the fourth low-noise amplifier is switched from the second impedance state to the first impedance state.

In this way, the second low-noise amplifier operates in the second frequency band by default, and may be reused to the first frequency band. The fourth low-noise amplifier operates in the first frequency band by default, and may be reused to the second frequency band. In this way, in the scenario of the first frequency band, the second low-noise amplifier may be reused, so as to increase utilization of the low-noise amplifier. In the scenario of the second frequency band, the fourth low-noise amplifier may be reused, so as to increase utilization of the low-noise amplifier. Therefore, when the maximum use scenario of the radio frequency module is unchanged, the quantity of required low-noise amplifiers is smaller, and a chip area is smaller.

In an implementation, the radio frequency module further includes: a third switch matrix, where the third switch matrix includes C input terminals and at least one output terminal, C is a positive integer, and C=N+M+K; where N input terminals of the third switch matrix are coupled to output terminals of the N first low-noise amplifiers in a one-to-one correspondence; and the at least one output terminal of the second switch matrix is coupled to at least one first output port in a one-to-one correspondence, and the first output port is a signal output port of the first frequency band.

In an implementation, M input terminals of the third switch matrix are in a one-to-one correspondence with output terminals of the M second low-noise amplifiers; and when the second low-noise amplifier is switched to the second impedance state, the second low-noise amplifier is coupled to an input terminal of the third switch matrix corresponding thereto.

In an implementation, K input terminals of the third switch matrix are in a one-to-one correspondence with output terminals of the K fourth low-noise amplifiers; and when the fourth low-noise amplifier is switched to the second impedance state, the second low-noise amplifier is coupled to an input terminal of the third switch matrix corresponding thereto. In this way, when the fourth low-noise amplifier is switched to the second impedance state, the radio frequency signal that is of the first frequency band and that is output by the fourth low-noise amplifier may be output to the outside through the third switch matrix.

In an implementation, the radio frequency module further includes: a fourth switch matrix, where the fourth switch matrix includes D input terminals and at least one output terminal, D is a positive integer, and D=M+K; and the at least one output terminal of the fourth switch matrix is coupled to at least one second output port in a one-to-one correspondence, and the second output port is a signal output port of the second frequency band.

In an implementation, M input terminals of the fourth switch matrix are in a one-to-one correspondence with the output terminals of the M second low-noise amplifiers; and when the second low-noise amplifier is switched to the first impedance state, the second low-noise amplifier is coupled to an input terminal of the fourth switch matrix corresponding thereto. In this way, when the second low-noise amplifier is switched to the first impedance state, the radio frequency signal that is of the second frequency band and that is output by the second low-noise amplifier may be output to the outside through the fourth switch matrix.

In an implementation, K input terminals of the fourth switch matrix are in a one-to-one correspondence with the output terminals of the K fourth low-noise amplifiers; and when the fourth low-noise amplifier is switched to the first impedance state, the fourth low-noise amplifier is coupled to an input terminal of the fourth switch matrix corresponding thereto. In this way, when the fourth low-noise amplifier is switched to the first impedance state, the radio frequency signal that is of the second frequency band and that is output by the fourth low-noise amplifier may be output to the outside through the fourth switch matrix.

In an implementation, each second low-noise amplifier is coupled to one or more internal input ports and/or auxiliary input ports of the first frequency band and coupled to one or more internal input ports and/or auxiliary input ports of the second frequency band by using a single-pole multi-throw switch.

In an implementation, each fourth low-noise amplifier is coupled to one or more internal input ports and/or auxiliary input ports of the first frequency band and coupled to one or more internal input ports and/or auxiliary input ports of the second frequency band by using a single-pole multi-throw switch.

According to a second aspect, an embodiment of this application provides a low-noise amplifier, including: a first transistor, where a gate of the first transistor is coupled to an input terminal of a radio frequency signal; a second transistor, where a source of the second transistor is coupled to a drain of the first transistor; a first inductor, where one terminal of the first inductor is coupled to a source of the first transistor, and the other terminal thereof is coupled to a ground; a second inductor, where one terminal of the second inductor is coupled to a drain of the second transistor, and the other terminal thereof is coupled to a power supply voltage; and an impedance adjustment network, where the impedance adjustment network includes: a first capacitor group, where the first capacitor group is coupled between the gate and the source of the first transistor, and the first capacitor group is configured to be switchable between a plurality of capacitance values; a second capacitor group, where the second capacitor group is coupled between the power supply voltage and the drain of the second transistor and is in parallel with the second inductor, and the second capacitor group is configured to be switchable between a plurality of capacitance values; and a third capacitor group, where the third capacitor group is coupled between an output terminal of the radio frequency signal and the drain of the second transistor, and the third capacitor group is configured to be switchable between a plurality of capacitance values; where the impedance adjustment network is configured to: enable the low-noise amplifier to be in a first impedance state and enable the low-noise amplifier to switch from the first impedance state to a second impedance state by switching capacitance values of the first capacitor group, the second capacitor group, and/or the third capacitor group; and the first impedance state includes: an input impedance and an output impedance of the low-noise amplifier match a second frequency band; the second impedance state includes: the input impedance and the output impedance of the low-noise amplifier match a first frequency band; and the second frequency band is lower than the first frequency band.

According to the low-noise amplifier provided in this embodiment of this application, by using the impedance adjustment network, the input impedance and the output impedance of the low-noise amplifier may be adjusted, so that the input impedance and the output impedance of the low-noise amplifier may be adjusted in a larger range, so as to match different frequency bands, and a bandwidth covered by the low-noise amplifier is increased, so that the low-noise amplifier can be used as a low-noise amplifier of an LB, and can be reused as a low-noise amplifier of an MHB. Therefore, when the low-noise amplifier provided in this embodiment of this application is applied to an LMH radio frequency module, a quantity of low-noise amplifiers can be reduced, and utilization of the low-noise amplifier can be improved.

In an implementation, the first frequency band is a middle band MB and/or a high band HB, and the second frequency band is a low band LB; or the first frequency band is a high band HB, and the first frequency band is a middle band MB.

In an implementation, an inductance value of the first inductor is configured to: when the capacitance value of the first capacitor group is switched to 0 pF, enable the input impedance of the low-noise amplifier to match a preset highest frequency band. In this way, a size of the first inductor may be reduced, and a Q value of the first inductor may be increased.

In an implementation, an inductance value of the second inductor is configured to: when the capacitance value of the second capacitor group is switched to 0 pF and the third capacitor group is switched to a preset minimum capacitance value, enable the output impedance of the low-noise amplifier to match the preset highest frequency band. In this way, a size of the second inductor may be reduced, and a Q value of the second inductor may be increased.

In an implementation, the first capacitor group includes a plurality of branches connected in parallel between the gate and the source of the first transistor, and one branch capacitor and one branch switch are disposed in series on each of the branches.

In an implementation, the second capacitor group includes a plurality of branches connected in parallel between the power supply voltage and the drain of the second transistor, and one branch capacitor and one branch switch are disposed in series on each of the branches.

In an implementation, the third capacitor group includes a plurality of branches connected in parallel between the output terminal of the radio frequency signal and the drain of the second transistor, and one capacitor and one branch switch are disposed in series on each of the branches.

In this way, a quantity of capacitors parallel to a circuit can be changed by controlling on and off of each branch switch, thereby changing the capacitance value of the capacitor group.

In an implementation, the first capacitor group includes a plurality of capacitors connected in series between the gate and the source of the first transistor, and each capacitor has one bypass switch in parallel.

In an implementation, the second capacitor group includes a plurality of capacitors connected in series between the power supply voltage and the drain of the second transistor, and each capacitor has one bypass switch in parallel.

In an implementation, the third capacitor group includes a plurality of capacitors connected in series between the output terminal of the radio frequency signal and the drain of the second transistor, and each capacitor has one bypass switch in parallel.

In this way, a quantity of capacitors in series in a circuit can be changed by controlling on and off of each bypass switch, thereby changing the capacitance value of the capacitor group.

According to a third aspect, an embodiment of this application further provides an electronic device, including: the radio frequency module provided in the first aspect and the implementations of the first aspect, and/or the low-noise amplifier provided in the second aspect and the implementations of the second aspect.

## BRIEF DESCRIPTION OF DRAWINGS

FIG. 1 is an example schematic structural diagram of a radio frequency module 10 according to an embodiment of this application;
FIG. 2 is an example schematic structural diagram of a radio frequency module 20 according to an embodiment of this application;
FIG. 3 is an example schematic structural diagram of a radio frequency module 30 according to an embodiment of this application;
FIG. 4 is an example schematic structural diagram of a radio frequency module 40 according to an embodiment of this application;
FIG. 5 is an example schematic structural diagram of a radio frequency module 50 according to an embodiment of this application;
FIG. 6 is an example schematic structural diagram of a radio frequency module 100 according to an embodiment of this application;
FIG. 7 is an example schematic structural diagram of a first LNA 110 according to an embodiment of this application;
FIG. 8 is a schematic diagram of a preferred implementation of a radio frequency module 100 according to an embodiment of this application;
FIG. 9 is an example schematic structural diagram of a radio frequency module 200 according to an embodiment of this application;
FIG. 10 is a schematic diagram of a preferred implementation of a radio frequency module 200 according to an embodiment of this application;
FIG. 11 is an example schematic structural diagram of a radio frequency module 300 according to an embodiment of this application;
FIG. 12 is a schematic diagram of a preferred implementation of a radio frequency module 300 according to an embodiment of this application;
FIG. 13 is an example schematic structural diagram of an LNA 500 according to an embodiment of this application;
FIG. 14 is a schematic diagram of an input impedance equivalent circuit of an LNA according to an embodiment of this application;
FIG. 15 is a schematic diagram of an inductor whose inductance value is adjustable;
FIG. 16 is a diagram of an output terminal equivalent circuit of an LNA according to an embodiment of this application;
FIG. 17A, FIG. 17B, and FIG. 17C are schematic diagrams of output impedance matching of an LNA according to an embodiment of this application;
FIG. 18A, FIG. 18B, and FIG. 18C are schematic diagrams of output impedance matching of an LNA according to an embodiment of this application;
FIG. 19 is a first schematic structural diagram of a capacitor group according to an embodiment of this application;
FIG. 20 is a second schematic structural diagram of a capacitor group according to an embodiment of this application;
FIG. 21 is a flowchart of determining capacitance values C1, C2, and C3 according to an embodiment of this application; and
FIG. 22A, FIG. 22B, FIG. 22C, and FIG. 22D are schematic performance diagrams of an LNA according to an embodiment of this application.

## DESCRIPTION OF EMBODIMENTS

A radio frequency module is an integrated circuit that can receive and transmit a radio frequency signal and process the radio frequency signal. A main function of the radio frequency module is to perform up-conversion and filtering on a baseband signal to obtain a radio frequency signal and transmit the radio frequency signal, and perform down-conversion and filtering on a received radio frequency signal to obtain a baseband signal.

The radio frequency module is an important component in an electronic device that has a wireless communication function, such as a mobile phone or a tablet computer. Based on the radio frequency module, the electronic device may implement signal transceiving and conversion of communication protocols such as 2G/3G/4G/5G, Wi-Fi, Bluetooth, GPS, UWB, LoRa, and NB-IoT.

In recent years, with development of technologies such as LTE, 5G NR, and Wi-Fi 6, the radio frequency module is becoming more integrated. For example, a radio frequency amplification module L-PAMiD that integrates a multi-mode multi-band radio frequency power amplifier PA, a low-noise amplifier LNA, a filter, a multiplexer, a switch, and a controller, and an L-PAMiF that integrates a radio frequency power amplifier, a radio frequency switch, a filter, and an LNA emerge.

In the radio frequency module, different components perform different tasks and coordinate with each other. For example, the radio frequency power amplifier is configured to amplify a radio frequency signal of a transmit channel. The LNA is configured to amplify a radio frequency signal of a receive channel. The multiplexer is configured to isolate a transmit signal and a receive signal. The filter is configured to retain a signal of a specific frequency band, and filter out a signal beyond the specific frequency band. The radio frequency switch is configured to implement transceiving and conversion of a radio frequency signal, and concentrate radio frequency signals of different frequency bands into a same channel.

In LTE, 5G NR, Wi-Fi 6, and future wireless communications technologies, carrier aggregation (carrier aggregation, CA) and multi-input multi-output (multi-input multi-output, MIMO) are important means for increasing a wireless transmission rate.

CA refers to a technology in which a radio frequency signal is received and transmitted by using carrier resources of two or more frequency bands at the same time, so as to increase a data transmission rate, for example, 2Inter-band component carriers (2Inter-band Component Carriers, Inter-band 2CC) that use carrier resources of two frequency bands at the same time and 3Inter-band Component Carriers (3Inter-band Component Carriers, Inter-band 3CC) that use carrier resources of three frequency bands at the same time.

MIMO is a technology in which a plurality of antennas are used at a transmit end to send radio frequency signals of a same frequency band, and a plurality of antennas are used at a receive end to receive radio frequency signals of a same frequency band, so as to increase a data transmission rate. For example, if radio frequency signals are sent by using two antennas at a transmit end, and radio frequency signals are received by using two antennas at a receive end, this may be referred to as 2×2 MIMO. If radio frequency signals are sent by using four antennas at a transmit end, and radio frequency signals are received by using three antennas at a receive end, this may be referred to as 4×3 MIMO. If radio frequency signals are sent by using m antennas at a transmit end, and radio frequency signals are received by using n antennas at a receive end, this may be referred to as m×n MIMO.

To meet requirements of CA and MIMO, the radio frequency module, such as an L-PAMiD module, may include a plurality of LNAs. Each LNA operates independently, and each LNA may be coupled to a signal input port of the radio frequency module to receive and process a radio frequency signal from the signal input port, or may be coupled to a plurality of signal input ports of the radio frequency module by using a radio frequency switch, and choose to receive a radio frequency signal from one signal input port thereof by switching the radio frequency switch. Therefore, in a CA scenario, if 2Inter-band component carriers are used, two LNAs are required to process radio frequency signals of two different frequency bands. If 3Inter-band component carriers are used, three LNAs are required to process radio frequency signals of three different bands. Similarly, in a MIMO scenario, if a receive end receives radio frequency signals by using two antennas, two LNAs are required to process two radio frequency signals of a same frequency band. If the receive end receives radio frequency signals by using three antennas, three LNAs are required to process three radio frequency signals of a same frequency band.

It can be learned that a quantity of LNAs required in the radio frequency module is related to a use scenario such as CA or MIMO.

The following exemplarily describes a quantity of LNAs required in some CA and MIMO scenarios.

For ease of understanding, wireless frequency band classification is first described by using an example.

Generally, wireless frequencies may be divided into a plurality of intervals in ascending order, for example, a low band LB, a middle band MB, and a high band HB, where the middle band MB is higher than the low band, and the high band HB is higher than the middle band.

Frequency band division of LTE is used as an example.

A frequency range of the low band LB may be between 617 MHz-960 MHz, for example, a Band 8 band (B8), a Band 26 band (B26), and a Band 28 band (B28) in LTE.

A frequency range of the middle band MB may be between 1710 MHz-2200 MHz, for example, a Band 1 band (B1), a Band 3 band (B3), a Band 34 band (B34), and a Band 39 band (B39) in LTE.

A frequency range of the high band HB is between 2300 MHz-2690 MHz, for example, a Band 40 band (B40) and a Band 41 band (B41) in LTE.

It should be noted herein that, in different division manners, frequency ranges corresponding to the low band LB, the middle band MB, and the high band HB may be different. For example, in 5G NR, the high band HB may refer to a frequency band higher than 6 GHz. Therefore, ranges of the low band LB, the middle band MB, and the high band HB are not specifically limited in the embodiments of this application.

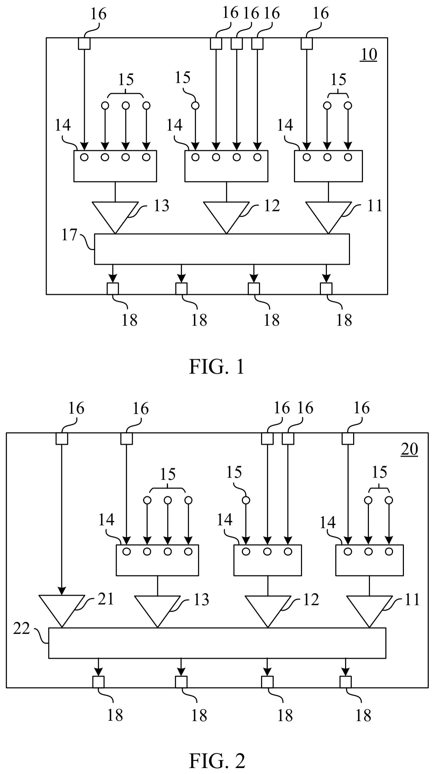

FIG. 1 is an example schematic structural diagram of a radio frequency module 10 according to an embodiment of this application.

As shown in FIG. 1, the radio frequency module 10 may be an L-PAMiD module or another radio frequency module, such as an LDiFEM or a radio frequency receiving module LNA bank. The radio frequency module includes an LNA 11, an LNA 12, and an LNA 13 that can operate on an MHB, to form an LNA combination on the MHB. An input terminal of each LNA may be coupled to an output terminal of a single-pole multi-throw SPxT switch 14 in a one-to-one correspondence. Each SPxT switch 14 includes a plurality of input terminals, and is configured to receive a radio frequency signal from an internal input port 15 of the MHB or an auxiliary input AUX IN port 16 of the MHB of the radio frequency module 10. By switching the SPxT switch 14, radio frequency signals of different frequency bands may be inputted into the LNA. A radio frequency signal output by each LNA may be outputted to a signal output port 18 of each MHB of the radio frequency module 10 by using a switch matrix 17. It may be understood that if the radio frequency module 10 includes four signal output ports 18, the switch matrix 17 may be a 3×4 switch array.

The radio frequency module 10 shown in FIG. 1 may meet a requirement of 2Inter-band component carriers CA. CA of the B1 band and the B3 band is used as an example. The LNA 12 may be configured to receive a radio frequency signal of the B1 band, and the LNA 13 may be configured to receive a radio frequency signal of the B3 band. Therefore, a total of two LNAs are required for 2Inter-band component carriers CA.

The radio frequency module 10 shown in FIG. 1 may further meet 2Inter-band component carriers CA accompanying a MIMO receiving requirement of one frequency band therein. In an example in which CA of the B1 band and the B3 band accompanies MIMO receiving of the B1 band, the LNA 12 may be configured to receive a radio frequency signal of the B1 band, the LNA 13 may be configured to receive a radio frequency signal of the B3 band, and the LNA 11 may be configured to receive a MIMO signal of the B1 band. It can be learned that 2Inter-band component carriers CA accompanying MIMO receiving of one frequency band therein requires a total of three LNAs.

FIG. 2 is an example schematic structural diagram of a radio frequency module 20 according to an embodiment of this application.

As shown in FIG. 2, based on the radio frequency module 10 shown in FIG. 1, the radio frequency module 20 adds one LNA 21 that can operate on the MHB. An input terminal of the LNA 21 is coupled to an auxiliary input port 16, an output terminal thereof is coupled to a switch matrix 22, and the switch matrix 22 may be a 4×4 switch array.

The radio frequency module 20 shown in FIG. 2 may meet 3Inter-band CA accompanying a MIMO receiving requirement of one frequency band therein. In an example in which CA of the B1 band, the B3 band, and the B41 band accompanies MIMO receiving of the B41 band, the LNA 12 may be configured to receive a radio frequency signal of the B1 band, the LNA 13 may be configured to receive a radio frequency signal of the B3 band, the LNA 11 may be configured to receive a radio frequency signal of the B41 band, and the LNA 21 may be configured to receive a MIMO signal of the B41 band. It can be learned that 3Inter-band component carriers CA accompanying MIMO receiving of one frequency band therein requires a total of four LNAs.

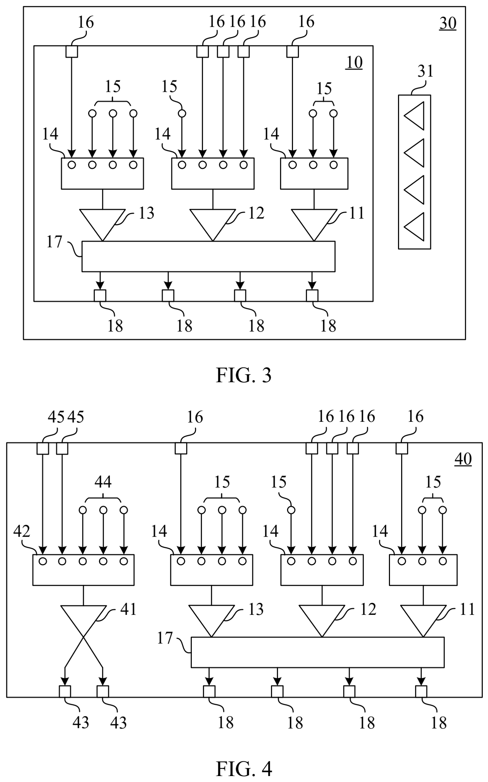

FIG. 3 is an example schematic structural diagram of a radio frequency module 30 according to an embodiment of this application.

As shown in FIG. 3, based on the radio frequency module 10 shown in FIG. 1, the radio frequency module 30 adds one external LNA bank 31. In this way, in an example in which CA of the B1 band, the B3 band, and the B41 band accompanies MIMO receiving of the B41 band, the LNA 12 may be configured to receive a radio frequency signal of the B1 band, the LNA 13 may be configured to receive a radio frequency signal of the B3 band, the LNA 11 may be configured to receive a radio frequency signal of the B41 band, and the LNA bank 31 may be configured to receive a MIMO signal of the B41 band. Therefore, 3Inter-band component carriers CA accompanying a MIMO receiving requirement of one frequency band therein is met.

It may be understood that, the radio frequency modules shown in FIG. 1 to FIG. 3 include a plurality of LNAs that can operate in the MB and the HB, to form an LNA combination of the MHB, which may meet a use scenario of the MHB. However, in a use process of an electronic device, in addition to the use scenario of the MHB, a use scenario of the LB may also be encountered.

Because an interval between the LB and the MHB is relatively long, a conventional LNA of the MHB cannot cover a bandwidth of the LB, and therefore cannot be used as an LNA of the LB. Similarly, a conventional LNA of the LB cannot cover a bandwidth of the MHB, and cannot be used as an LNA of the MHB.

In addition, even if a frequency coverage range of the LNA is increased by using technologies such as negative feedback, multi-stage, and distributed, for example, the LB and the MB are covered, a use requirement cannot be met. For example, if the frequency coverage range of the LNA is increased to 617 MHz~2200 MHz, a bandwidth range of the LNA is 1583 MHz, and a relative bandwidth reaches 112%, which severely reduces a gain, increases a noise coefficient, and cannot meet a use requirement.

Therefore, to meet use requirements of both the MHB and the LB, some radio frequency modules include not only an LNA of the MHB but also an LNA of the LB.

FIG. 4 is an example schematic structural diagram of a radio frequency module 40 according to an embodiment of this application.

As shown in FIG. 4, based on the radio frequency module 10 shown in FIG. 1, the radio frequency module 40 adds one LNA 41 of the LB. An input terminal of the LNA 41 is coupled to an SPxT switch 42, and an output terminal of the LNA 41 is coupled to one or more signal output ports 43 of the LB of the radio frequency module 40. The SPxT switch 42 includes a plurality of input terminals, and is configured to receive a radio frequency signal from an internal input port 44 of the LB or an auxiliary input AUX IN port 45 of the LB of the radio frequency module 40.

The radio frequency module 40 shown in FIG. 4 may meet 2Inter-band CA accompanying a MIMO receiving requirement of one frequency band in 2Inter-band CA in an MHB scenario, and may further meet a single-band receiving requirement in an LB scenario.

For example, for the MHB scenario, in an example in which CA of the B1 band and the B3 band accompanies MIMO receiving of the B1 band, the LNA 12 may be configured to receive a radio frequency signal of the B1 band, the LNA 13 may be configured to receive a radio frequency signal of the B3 band, and the LNA 11 may be configured to receive a MIMO signal of the B1 band. In this scenario, the LNA 41 is in an idle state. For the LB scenario, the LNA 41 may receive, for example, a radio frequency signal of, such as, the B26 band, the B28 band, or the B8 band. In this scenario, the LNA 11, the LNA 12, and the LNA 13 are all in an idle state.

In some LB scenarios, there is also a MIMO receiving requirement or a CA requirement of the LB, for example, MIMO receiving is performed on the B28 band, so as to increase a transmission speed, or 2Inter-band CA receiving is performed on the B8 band and the B28 band. Therefore, to meet the MIMO requirement or the CA requirement of the LB, some radio frequency modules may include two or more LNAs of the LB.

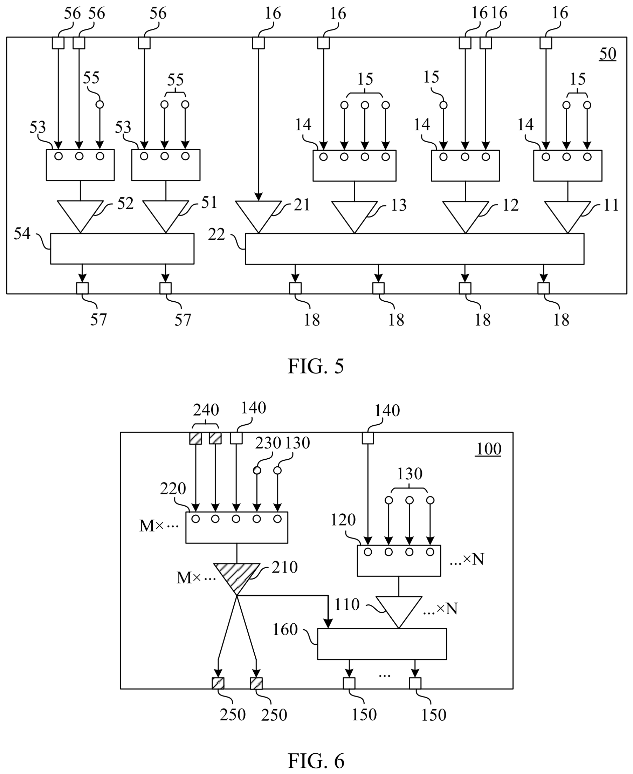

FIG. 5 is an example schematic structural diagram of a radio frequency module 50 according to an embodiment of this application.

As shown in FIG. 5, based on the radio frequency module 20 shown in FIG. 2, the radio frequency module 50 adds an LNA 51 and an LNA 52 of the LB, two SPxT switches 53 that are in a one-to-one correspondence with the LNA 51 and the LNA 52, and a switch matrix 54. An input terminal of each LNA of the LB may be coupled to an output terminal of an SPxT switch 53 in a one-to-one correspondence. Each SPxT switch 53 includes a plurality of input terminals, and is configured to receive a radio frequency signal from an internal input port 55 of the LB or an auxiliary input port 56 of the LB of the radio frequency module 50. The switch matrix 54 may be a 2×2 switch array or DPDT. Two input terminals of the switch matrix 54 are coupled to output terminals of the LNA 51 and the LNA 52 in a one-to-one correspondence, and two output terminals of the switch matrix 54 are coupled to two signal output ports 57 of the LB of the radio frequency module 50.

The radio frequency module shown in FIG. 5 may meet 3Inter-band CA accompanying a MIMO receiving requirement of one frequency band therein in an MHB scenario, and may further meet a MIMO receiving requirement or a 2Inter-band CA receiving requirement in an LB scenario.

For example, for the MHB scenario, in an example in which CA of the B1 band, the B3 band, and the B41 band accompanies MIMO receiving of the B41 band, the LNA 11 may be configured to receive a radio frequency signal of the B41 band, the LNA 12 may be configured to receive a radio frequency signal of the B1 band, the LNA 13 may be configured to receive a radio frequency signal of the B3 band, and the LNA 14 may be configured to receive a MIMO signal of the B41 band. In this scenario, both the LNA 51 and the LNA 52 of the LB are in an idle state.

For example, for the LB scenario, MIMO receiving of the B28 band is used as an example. The LNA 51 may be configured to receive a radio frequency signal of the B28 band, and the LNA 52 may be configured to receive a MIMO signal of the B28 band. In this scenario, the LNA 11, the LNA 12, the LNA 13, and the LNA 14 of the MB are all in an idle state.

It may be understood that, to enable the radio frequency module to be applied to various use scenarios of the MHB and the LB, a quantity of LNAs in the radio frequency module is generally determined according to a maximum requirement in each use scenario. Therefore, the radio frequency module may be designed as the structure shown in FIG. 4, including one LNA of the LB and three LNAs of the MHB, or may be designed as the structure shown in FIG. 5, including two LNAs of the LB and four LNAs of the MHB.

However, in actual use, when the radio frequency module operates in the MHB scenario, the LNA of the LB is idle, and when the radio frequency module operates in the LB scenario, the LNA of the MHB is idle. Consequently, utilization of the LNAs of the radio frequency module is not high. In addition, each LNA occupies chip space in the radio frequency module. Therefore, when the radio frequency module is designed according to a maximum requirement, a quantity of LNAs is large, which results in a large size of the radio frequency module which is difficult to be applied to a small-sized electronic device such as a mobile phone.

An embodiment of this application provides a radio frequency module, which can increase utilization of an LNA in the radio frequency module and reduce a quantity of LNAs.

FIG. 6 is an example schematic structural diagram of a radio frequency module 100 according to an embodiment of this application.

As shown in FIG. 6, the radio frequency module 100 may include:

N first LNA 110 coupled between a signal input port and a signal output port, where N is a positive integer.

In some embodiments, the signal input port may be an internal input port of the radio frequency module, or may be an auxiliary input port of the radio frequency module.

For example, the radio frequency module 100 may include one or more filters. An input terminal of the filter may be coupled to a radio frequency antenna, and is configured to: receive an antenna signal, and filter the antenna signal to obtain a radio frequency signal of a specific frequency. An output terminal of the filter may be coupled to an input terminal of the LNA, and is configured to input a radio frequency signal into the LNA. Therefore, the output terminal of the filter may be considered as an internal input port of the radio frequency module 100.

For example, the radio frequency module 100 may include one or more auxiliary input ports, and the auxiliary input port may be an external input port of the radio frequency module 100, and is configured to receive a radio frequency signal from an external component. The auxiliary input port may be coupled to an input terminal of the LNA and is configured to input a radio frequency signal into the LNA. In this way, when an antenna signal filtering procedure is completed outside the radio frequency module 100, an external radio frequency signal may enter the radio frequency module 100 by using the auxiliary input port, and be input into the LNA.

In some embodiments, an input impedance and an output impedance of the first LNA 110 match a first frequency band.

The first frequency band may be a middle band MB and/or a high band HB. That is, the input impedance and the output impedance of the first LNA may match the MB and/or the HB, thereby amplifying and outputting a radio frequency signal of the MB and/or the HB. It should be noted herein that the MB and the HB are each a relatively large frequency band range, and include a plurality of LTE frequency bands, NR frequency bands, and the like. Therefore, that the input impedance and the output impedance of the first LNA 110 in this embodiment of this application match the first frequency band does not mean that the input impedance and the output impedance of the first LNA 110 match all frequency bands in the MB and the HB, but match a specific frequency band or some specific frequency bands of the MB and the HB based on an actual requirement.

It should be noted herein that in a design of a radio frequency circuit, impedance matching means that an input impedance of the circuit is enabled to match a source impedance of a signal source by using a proper design and configuration in the circuit, and an output impedance of the circuit is enabled to match a load impedance of a connected load to implement a maximum gain of the circuit.

In this embodiment of this application, that the input impedance of the LNA matches a frequency band (for example, the first frequency band or a second frequency band) may refer to adjusting an imaginary part of the input impedance of the LNA to 0 or near 0 in a frequency band. That the output impedance of the LNA matches a frequency band (for example, the first frequency band or the second frequency band) may refer to enabling a source impedance and a load impedance of the LNA to implement conjugate matching in a frequency band.

For example, when there are a plurality of first LNAs, an input impedance and an output impedance of one first LNA 110 may match the B40 band and the B41, an input impedance and an output impedance of another first LNA 110 may match the B1 band, and an input impedance and an output impedance of another first LNA 110 may match the B1 band, the B39 band, and/or the B34 band. This is not specifically limited in this embodiment of this application.

In some embodiments, the input terminal of each first LNA 110 may be coupled to one or more internal input ports 130 of the first frequency band and/or one or more auxiliary input ports 140 of the first frequency band by using an SPxT switch 120. In this way, by switching the SPxT switch 120, the input terminal of the first LNA 110 may be conducted to any internal input port 130 or any auxiliary input port 140, so as to receive a radio frequency signal from a corresponding port.

It should be further noted herein that wireless networks provided by different countries, regions, and operators may operate in different frequency bands, and a quantity of frequency bands may also be different. Therefore, to adapt to different networks, a quantity of input terminals of each SPxT switch 120 and specific frequency bands corresponding to each internal input port 130 and auxiliary input port 140 may be different, which may be specifically determined according to an actual requirement. This is not specifically limited in this embodiment of this application.

In some embodiments, the first LNA may be a legacy LNA of the MB, a legacy LNA of the HB, and/or a legacy LNA of the MHB. The following exemplarily describes a structure of the first LNA with reference to the accompanying drawings.

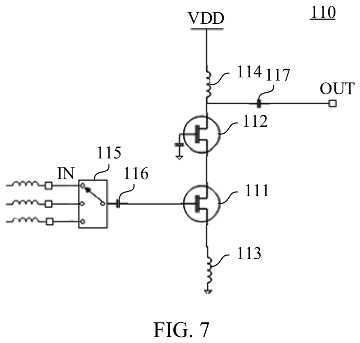

FIG. 7 is an example schematic structural diagram of a first LNA 110 according to an embodiment of this application.

As shown in FIG. 7, the first LNA 110 may include an input terminal transistor 111, an output terminal transistor 112, an input terminal inductor 113, an output terminal inductor 114, and an SPxT switch 115. A source of the output terminal transistor 112 is coupled to a drain of the input terminal transistor 111, a gate of the output terminal transistor 112 is coupled to a ground, and a drain of the output terminal transistor 112 is coupled to an output terminal OUT of the first LNA 110. One terminal of the input terminal inductor 113 is coupled to a source of the input terminal transistor 111, and the other terminal thereof is coupled to the ground. One terminal of the output terminal inductor 114 is coupled to the drain of the output terminal transistor 112, and the other terminal thereof is coupled to a power supply voltage VDD. A plurality of input terminals IN of the SPxT switch 115 are configured to be coupled to a plurality of signal input ports of the radio frequency module, and an output terminal of the SPxT switch 115 is coupled to a gate of the input terminal transistor 111 and is configured to input a radio frequency signal. An input DC-blocking capacitor 116 is further disposed between the output terminal of the SPxT switch 115 and the gate of the input terminal transistor 111, and an output DC-blocking capacitor 117 is further disposed between the drain of the output terminal transistor 112 and the output terminal OUT of the first LNA 110.

As a conventional LNA, an inductance value of the input terminal inductor 113, an inductance value of the output inductor 114, a capacitance value of the input capacitor 116, and a capacitance value of the output DC-blocking capacitor 117 are all fixed values, so that an input impedance and an output impedance of the first LNA 110 match a corresponding frequency band. That is, in this embodiment of this application, the inductance value of the input terminal inductor 113, the inductance value of the output inductor 114, the capacitance value of the input DC-blocking capacitor 116, and the capacitance value of the output DC-blocking capacitor 117 enable the input impedance and the output impedance of the first LNA 110 to match an MB band and an HB band. Therefore, it may be understood that, because impedance matching of different frequency bands requires different inductor and capacitor magnitudes, the foregoing capacitance value and inductance value cannot enable the input impedance and the output impedance of the first LNA to match the LB band, and therefore, the first LNA 110 cannot be used as an LNA of the LB.

Further, as shown in FIG. 6, the radio frequency module further includes:

M second LNAs 210 coupled between the signal input port and the signal output port, where M is a positive integer.

In some embodiments, the second LNA 210 is configured as a first impedance state, and the first impedance state includes: An input impedance and an output impedance of the second LNA 210 match a second frequency band, the second frequency band is lower than the first frequency band, and the first impedance state may be a default impedance state of the second LNA 210. When the second LNA 210 is in the first impedance state, the second LNA 210 may amplify and output a radio frequency signal of the second frequency band.

In some embodiments, the second LNA 210 includes a first impedance adjustment network, and the first impedance adjustment network is configured to adjust the input impedance and/or the output impedance of the second LNA 210, so that the second LNA 210 is switched from the first impedance state to a second impedance state. The second impedance state includes: The input impedance and the output impedance of the second LNA 210 match the first frequency band. The second impedance state may be an impedance state reused by the second LNA 210. When the second LNA 210 is in the second impedance state, the second LNA 210 may amplify and output a radio frequency signal of the first frequency band.

The second frequency band may be a low band LB, that is, in the first impedance state, the second LNA 210 may amplify and output a radio frequency signal of the LB. It should be noted herein that the LB is a relatively large frequency band range, and includes a plurality of LTE frequency bands, NR frequency bands, and the like. Therefore, that the input impedance and the output impedance of the second LNA 210 in this embodiment of this application match the second frequency band does not mean that the input impedance and the output impedance of the second LNA 210 match all frequency bands in the LB, but match a specific frequency band or some specific frequency bands of the LB based on an actual requirement.

It should be noted herein that, in this embodiment of this application, compared with that the first LNA 110 can only amplify and output a radio frequency signal of the first frequency band, the second LNA 210 can not only amplify and output a radio frequency signal of the second frequency band, but also implement reuse in a manner of switching the impedance state, that is, amplify and output a radio frequency signal of the first frequency band.

For example, when in the first impedance state, the second LNA 210 amplifies and outputs the radio frequency signal of the LB. In this case, the first impedance adjustment network may be used to switch the second LNA 210 from the first impedance state to the second impedance state, so that the second LNA 210 is switched to amplifying and outputting a radio frequency signal of the MHB. For another example, when the second LNA 210 is in the second impedance state, the second LNA 210 may be switched from the second impedance state to the first impedance state by using the first impedance adjustment network, so that the second LNA 210 is switched to amplifying and outputting a radio frequency signal of the LB.

In some embodiments, an input terminal of each second LNA 210 may be coupled to one or more signal input ports of the second frequency band and one or more signal input port of the first frequency band of the radio frequency module by using an SPxT switch 220. The signal input port of the second frequency band may be an internal input port 230 of the second frequency band and/or an auxiliary input port 240 of the second frequency band, and the signal input port of the first frequency band may be an internal input port 130 of the first frequency band and/or an auxiliary input port 140 of the first frequency band. In this way, by switching the SPxT switch, the input terminal of the second LNA 210 is conducted to any one of the internal input port 230, the internal input port 130, the auxiliary input port 240, or the auxiliary input port 140, so as to receive a radio frequency signal from a corresponding port.

It may be understood that, to separately output the radio frequency signal of the first frequency band and the radio frequency signal of the second frequency band to the outside of the radio frequency module 100, the signal output port of the radio frequency module 100 may include a signal output port 150 of the first frequency band and a signal output port 250 of the second frequency band.

The radio frequency signal of the first frequency band outputted from the first LNA 110 may be outputted to the outside from the signal output port 150. When the second LNA 210 is in the first impedance state, the radio frequency signal of the second frequency band outputted from the second LNA 210 may be outputted to the outside from the signal output port 250. When the second LNA 210 is in the second impedance state, the radio frequency signal of the first frequency band outputted from the second LNA 210 may be outputted to the outside from the signal output port 150.

In some embodiments, as shown in FIG. 6, the radio frequency module 100 may further include a first switch matrix 160. The first switch matrix 160 may include A input terminals and at least one output terminal, where A is a positive integer, and A=M+N. A quantity of input terminals of the first switch matrix 160 is equal to a sum of a quantity of first LNAs 110 and a quantity of second LNAs 210, and a quantity of output terminals may be 4, 6, or another quantity, and may be the same as or different from the quantity of input terminals, which is not specifically limited herein.

For example, if the quantity of first LNAs 110 is 3 and the quantity of second LNAs 210 is 1, that is, N=3 and M=1, the first switch matrix 160 may be a 4×4 switch array. If the quantity of first LNAs 110 is 4 and the quantity of second LNAs 210 is 1, that is, N=4 and M=1, the first switch matrix 160 may be a 5×4 switch array.

N input terminals of the first switch matrix 160 are coupled in a one-to-one correspondence to output terminals of the N first LNAs 110, and are configured to receive radio frequency signals of the first frequency band outputted by the N first LNAs 110. M input terminals of the first switch matrix 160 are in a one-to-one correspondence with output terminals of the M second LNAs 210. When the second LNA 210 is switched to the second impedance state, the output terminal of the second LNA 210 is coupled to an input terminal of a first switch matrix 160 corresponding thereto. In this way, the M input terminals of the first switch matrix 160 may receive radio frequency signals of the first frequency band outputted by the M second LNAs 210.

For example, if the quantity of first LNAs 110 is 3 and the quantity of second LNAs 210 is 1, that is, N=3 and M=1, output terminals of the three first LNAs 110 are coupled to three input terminals of the first switch matrix 160 in a one-to-one correspondence, and an output terminal of one second LNA 210 may be coupled to a remaining one input terminal of the first switch matrix 160.

Further, at least one output terminal of the first switch matrix 160 is coupled to at least one signal output port 150 of the first frequency band of the radio frequency module 100 in a one-to-one correspondence, and is configured to output the radio frequency signal of the first frequency band through at least one signal output port 150.

In some embodiments, as shown in FIG. 6, when the second LNA 210 is switched to the first impedance state, the second LNA 210 may be coupled to one or more signal output ports 250. For example, the second LNA 210 may be directly coupled to one or more signal output ports 250 without using a switch matrix.

For example, the radio frequency module 100 may include one second LNA 210 and one signal output port 250, and an output terminal of the second LNA 210 may be coupled to the signal output port 250 without using a switch matrix.

For example, the radio frequency module 100 may include one second LNA 210 and two signal output ports 250, and an output terminal of the second LNA 210 may be coupled to the two signal output ports 250 without using a switch matrix.

Certainly, when the quantity of second LNAs 210 is a plurality of, and the quantity of signal output ports 250 is a plurality of, the plurality of second LNAs 210 may also be coupled to the plurality of signal output ports 250 by using a switch matrix, which is not limited in this embodiment of this application.

According to the radio frequency module provided in this embodiment of this application, an impedance adjustment network is added to the second LNA, and the input impedance and the output impedance of the second LNA may be adjusted by using the impedance adjustment network, so that the second LNA can be switched between different impedance states, so as to match different frequency bands. In this way, the second LNA may be used as an LNA of the second frequency band, and may be reused as an LNA of the first frequency band, thereby increasing utilization of the LNA. In a case in which a maximum use scenario is unchanged, the radio frequency module requires a smaller quantity of LNAs, and a chip area is smaller.

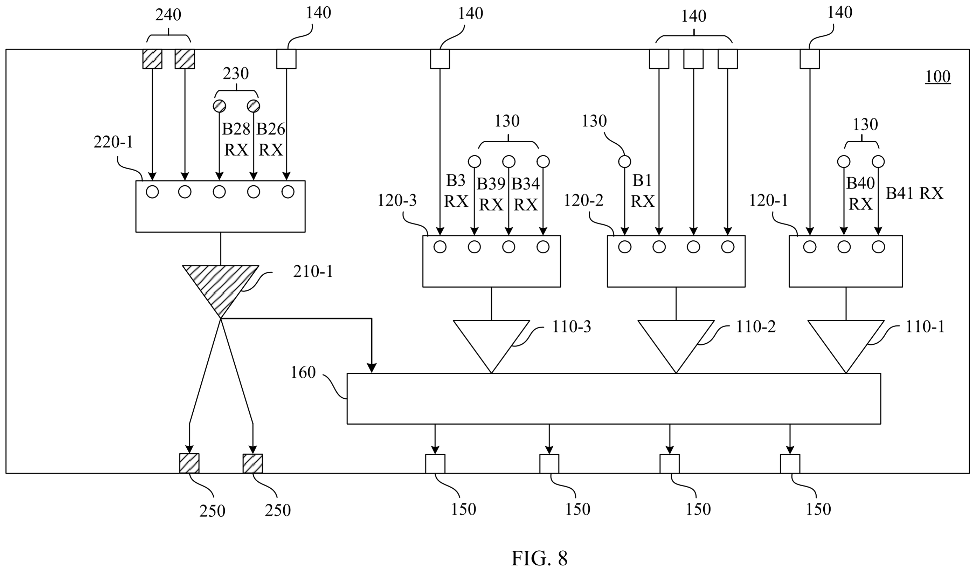

FIG. 8 is a schematic diagram of a preferred implementation of a radio frequency module 100 according to an embodiment of this application.

With reference to FIG. 8, the following exemplarily describes a preferred implementation of the radio frequency module 100 shown in FIG. 6 with three first LNAs 110 and one second LNA 210.

For example, as shown in FIG. 8, the radio frequency module 100 may include a first LNA 110-1, a first LNA 110-2, and a first LNA 110-3 that are coupled between a signal input port and a signal output port, and a second LNA 210-1.

For example, an SP3T switch 120-1 is disposed on an input terminal of the first LNA 110-1. One input terminal of the SP3T switch 120-1 is coupled to one auxiliary input port 140 of an MHB of the radio frequency module 100. The other two input terminals of the SP3T switch 120-1 are coupled to internal input ports 130 of the MHB of the radio frequency module 100 in a one-to-one correspondence, and are respectively configured to receive (RX) a radio frequency signal of the B40 band and a radio frequency signal of the B41 band.

For example, an SP4T switch 120-2 is disposed on an input terminal of the first LNA 110-2. Three input terminals of the SP4T switch 120-2 are coupled to three auxiliary input ports 140 of the MHB of the radio frequency module 100 in a one-to-one correspondence. The other input terminal of the SP4T switch is coupled to an internal input port 130 of the MHB of the radio frequency module 100, and is configured to receive a radio frequency signal of the B1 band.

For example, an SP4T switch 120-3 is disposed on an input terminal of the first LNA 110-3. One input terminal of the SP4T switch 120-3 is coupled to one auxiliary input port 140 of the MHB of the radio frequency module 100. The other three input terminals of the SP4T switch are coupled to three internal input ports 130 of the MHB of the radio frequency module 100 in a one-to-one correspondence, and are respectively configured to receive a radio frequency signal of the B3 band, a radio frequency signal of the B39 band, and a radio frequency signal of the B34 band.

For example, an SP5T switch 220-1 is disposed on an input terminal of the second LNA 210-1. Two input terminals of the SP5T switch 220-1 are coupled to two auxiliary input ports 240 of the LB of the frequency module 100 in a one-to-one correspondence, and are configured to receive radio frequency signals of the LB. Another two input terminals of the SP5T switch 220-1 are coupled to two internal input ports 230 of the LB of the frequency module 100 in a one-to-one correspondence, and are respectively configured to receive a radio frequency signal of the B26 band and a radio frequency signal of the B28 band. The remaining one input terminal of the SP5T switch 220-1 is coupled to one auxiliary input port 140 of the MHB of the radio frequency module 100, and is configured to receive a radio frequency signal of the MHB.

For example, the first switch matrix 160 is a 4×4 switch array. Three input terminals of the first switch matrix 160 are coupled to output terminals of three first LNAs 110 in a one-to-one correspondence, and are configured to receive radio frequency signals of the MHB outputted by the three first LNAs 110. The remaining one input terminal of the first switch matrix 160 is coupled to an output terminal of the second LNA 210-1. In this way, when the second LNA 210-1 is switched to a second impedance state, the first switch matrix 160 may receive a radio frequency signal of the MHB outputted by the second LNA 210-1. Further, four output terminals of the first switch matrix 160 are coupled to four signal output ports 150 of the MHB of the radio frequency module 100 in a one-to-one correspondence, and are configured to output a radio frequency signal of the MHB through one or more of the four signal output ports 150.

For example, the output terminal of the second LNA 210 may be directly coupled to two signal output ports 250 of the LB without using the switch matrix 160. In this way, when the second LNA 210 is switched to a first impedance state, a radio frequency signal of the LB may be outputted through one or more of the two signal output ports 250 of the LB.

In the radio frequency module shown in FIG. 8, when the second LNA 210-1 is switched to the first impedance state, a single-band receiving requirement in an LB scenario may be met. When the second LNA 210-1 is switched to the second impedance state, 3Inter-band CA accompanying a MIMO receiving requirement of one frequency band therein in an MHB scenario may be met. In an example in which CA of the B1 band, the B3 band, and the B41 band accompanies MIMO receiving of the B41 band, the first LNA 110-2 may be configured to receive a radio frequency signal of the B1 band, the first LNA 110-3 may be configured to receive a radio frequency signal of the B3 band, the first LNA 110-1 may be configured to receive a radio frequency signal of the B41 band, and the second LNA 210-1 may be configured to receive a MIMO signal of the B41 band.

It may be learned that, compared with the radio frequency module 20 shown in FIG. 2, the radio frequency module 100 shown in FIG. 8 can additionally meet a single-band receiving requirement in an LB scenario in a case in which a quantity of LNAs is the same. Compared with the radio frequency module 40 shown in FIG. 4, in a case in which a quantity of LNAs is the same, the radio frequency module 100 shown in FIG. 8 reuses the second LNA 210-1 to the MHB band, which can additionally meet 3Inter-band CA accompanying a MIMO receiving requirement of one frequency band therein in the MHB scenario. If only 2Inter-band CA accompanying a MIMO receiving requirement of one frequency band therein needs to be met, the radio frequency module shown in FIG. 8 may reduce one LNA of the MHB band compared with the radio frequency module 40 shown in FIG. 4.

It can be learned that, in the radio frequency module provided in this embodiment of this application, in a case in which the quantity of LNAs is not increased, a larger use scenario can be met, and utilization of the LNA is higher. In a case in which a same use scenario is met, a quantity of required LNAs is smaller.

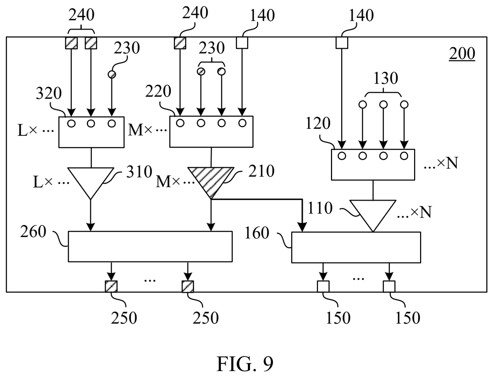

FIG. 9 is an example schematic structural diagram of a radio frequency module 200 according to an embodiment of this application.

As shown in FIG. 9, in an embodiment, based on the radio frequency module 100 shown in FIG. 6, the radio frequency module 200 may further include:
L third LNAs 310 coupled between the signal input port and the signal output port, where L is a positive integer.

In some embodiments, an input impedance and an output impedance of the third LNA 310 match the second frequency band. That is, the input impedance and the output impedance of the third LNA 310 may match the LB, thereby amplifying and outputting a radio frequency signal of the LB. It should be noted herein that the LB is a relatively large frequency band range, and includes a plurality of LTE frequency bands, NR frequency bands, and the like. Therefore, that the input impedance and the output impedance of the third LNA 310 in this embodiment of this application match the second frequency band does not mean that the input impedance and the output impedance of the third LNA 310 match all frequency bands in the LB, but match a specific frequency band or some specific frequency bands of the LB based on an actual requirement.

In some embodiments, the input terminal of each third LNA 310 may be coupled to one or more internal input ports 230 of the second frequency band and/or one or more auxiliary input ports 240 of the second frequency band by using an SPxT switch 320. In this way, by switching the SPxT switch 320, the input terminal of the third LNA 310 may be conducted to any internal input port 230 or any auxiliary input port 240, so as to receive a radio frequency signal from a corresponding port.

The third LNA 310 may be a conventional LNA. A specific structure may be implemented by referring to FIG. 7. When the LNA shown in FIG. 7 is used as the third LNA 310, the inductance value of the input terminal inductor, the inductance value of the output terminal inductor, the capacitance value of the input DC-blocking capacitor, and the capacitance value of the output DC-blocking capacitor enable the input impedance and the output impedance of the third LNA 310 to match the second frequency band.

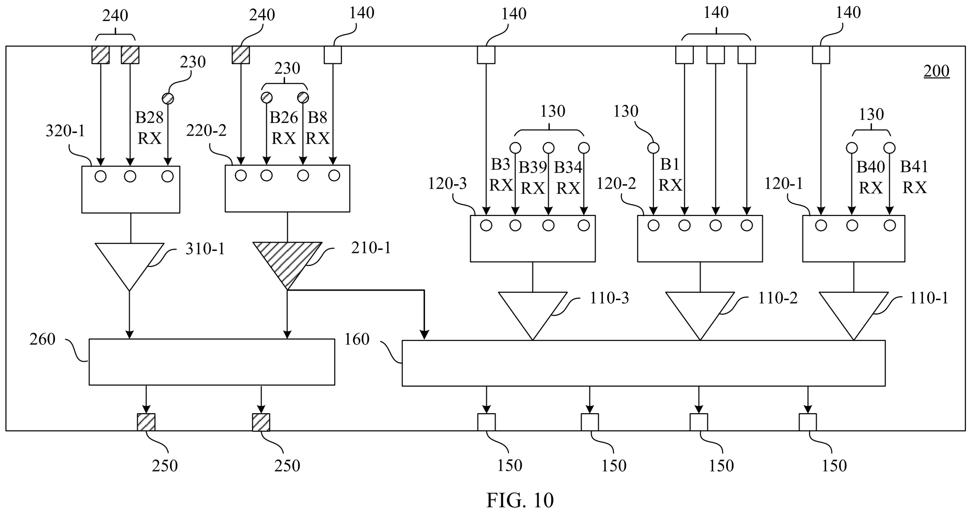

In some embodiments, as shown in FIG. 10, the radio frequency module 200 may further include a second switch matrix 260. The second switch matrix 260 may include B input terminals and at least one output terminal, B is a positive integer, and B=M+L. A quantity of input terminals of the second switch matrix 260 is equal to a sum of a quantity of second LNAs 210 and a quantity of third LNAs 310, and a quantity of output terminals may be 2, 4, or another quantity, and may be the same as or different from the quantity of input terminals, which is not specifically limited herein.

For example, if the quantity of second LNAs 210 is 1, the quantity of third LNAs 310 is 1, that is, M=1 and L=1. In this case, the second switch matrix 260 may be a 2×2 switch array, that is, DPDT. If the quantity of second LNAs 210 is 1 and the quantity of third LNAs 310 is 2, that is, M=1 and L=2, the second switch matrix 260 may be a 3×2 switch array.

L input terminals of the second switch matrix 260 are coupled in a one-to-one correspondence to output terminals of the L third LNAs 310, and are configured to receive radio frequency signals of the second frequency band outputted by the L third LNAs 310. M input terminals of the second switch matrix 260 are in a one-to-one correspondence with the output terminals of the M second LNAs 210. When the second LNA 210 is switched to the first impedance state, the output terminal of the second LNA 210 is coupled to an input terminal of a second switch matrix 260 corresponding thereto. In this way, the M input terminals of the second switch matrix 260 may receive radio frequency signals of the second frequency band outputted by the M second LNAs 210.

For example, if the quantity of second LNAs 210 is 1, the quantity of third LNAs 310 is 1, that is, M=1 and L=1. Then, the output terminal of the second LNA 210 may be coupled to one input terminal of the second switch matrix 260, and the output terminal of the third LNA 310 is coupled to another input terminal of the second switch matrix 260.

Further, at least one output terminal of the second switch matrix 260 is coupled to at least one signal output port 250 of the second frequency band of the radio frequency module 200 in a one-to-one correspondence, and is configured to output the radio frequency signal of the second frequency band through at least one signal output port 250.

According to the radio frequency module provided in this embodiment of this application, based on the second LNA being included, a third LNA that can operate on the second frequency band is added, which meets a CA or MIMO requirement of the second frequency band.

For content not specifically expanded in FIG. 9, refer to FIG. 6 for implementation. Details are not described herein again.

FIG. 10 is a schematic diagram of a preferred implementation of a radio frequency module 200 according to an embodiment of this application.

With reference to FIG. 10, the following exemplarily describes a preferred implementation of the radio frequency module 200 shown in FIG. 9 with three first LNAs 110, one second LNA 210, and one third LNA 310.

For example, as shown in FIG. 10, the radio frequency module 200 may include a first LNA 110-1, a first LNA 110-2, a first LNA 110-3, a second LNA 210-1, and a third LNA 310-1 that are coupled between a signal input port and a signal output port.

For example, an SP3T switch 120-1 is disposed on an input terminal of the first LNA 110-1. An output terminal of the SP3T switch 120-4 is coupled to an input terminal of the first LNA 110-1. One input terminal of the SP3T switch 120-1 is coupled to an auxiliary input port 140 of an MHB of the radio frequency module 200. The other two input terminals of the SP3T switch 120-1 are coupled to two internal input ports 130 of the MHB of the radio frequency module 200 in a one-to-one correspondence, and are respectively configured to receive a radio frequency signal of the B40 band and a radio frequency signal of the B41 band.

For example, an SP4T switch 120-2 is disposed on an input terminal of the first LNA 110-2. Three input terminals of the SP4T switch 120-2 are coupled to three auxiliary input ports 140 of the MHB of the radio frequency module 200 in a one-to-one correspondence. The other input terminal of the SP4T switch is coupled to an internal input port 130 of the MHB of the radio frequency module 200, and is configured to receive a radio frequency signal of the B1 band.

For example, an SP4T switch 120-3 is disposed on an input terminal of the first LNA 110-3. One input terminal of the SP4T switch 120-3 is coupled to one auxiliary input port 140 of the MHB of the radio frequency module 200. The other three input terminals of the SP4T switch are coupled to three internal input ports 130 of the MHB of the radio frequency module 200 in a one-to-one correspondence, and are respectively configured to receive a radio frequency signal of the B3 band, a radio frequency signal of the B39 band, and a radio frequency signal of the B34 band.

For example, an SP4T switch 220-2 is disposed on an input terminal of the second LNA 210-1. One input terminal of the SP4T switch 220-2 is coupled to one auxiliary input port 240 of the LB of the radio frequency module 200, and is configured to receive a radio frequency signal of the LB. One input terminal of the SP4T switch 220-2 is coupled to one auxiliary input port 140 of the MHB of the radio frequency module 200, and is configured to receive a radio frequency signal of the MHB. The other two input terminals of the SP4T switch are coupled to two internal input ports 230 of the LB of the frequency module 200 in a one-to-one correspondence, and are respectively configured to receive a radio frequency signal of the B26 band and a radio frequency signal of the B8 band.

For example, an SP3T switch 320-1 is disposed on an input terminal of the third LNA 310-1. An output terminal of the SP3T switch 320-1 is coupled to the input terminal of the third LNA 310-1. Two input terminals of the SP3T switch 320-1 are coupled to two auxiliary input ports 240 of the LB of the radio frequency module 200 in a one-to-one correspondence, and are configured to receive radio frequency signals of the LB. The other input terminal of the SP3T switch 320-1 is coupled to an internal input port 230 of the LB of the radio frequency module 200, and is configured to receive a radio frequency signal of the B28 band.

For example, the first switch matrix 160 is a 4×4 switch array. Three input terminals of the first switch matrix 160 are coupled to output terminals of three first LNAs 110 in a one-to-one correspondence, and are configured to receive radio frequency signals of the MHB outputted by the three first LNAs 110. The remaining one input terminal of the first switch matrix 160 is coupled to an output terminal of the second LNA 210-1. In this way, when the second LNA 210-1 is switched to a second impedance state, the first switch matrix 160 may receive a radio frequency signal of the MHB outputted by the second LNA 210-1. Further, four output terminals of the first switch matrix 160 are coupled to four signal output ports 150 of the MHB of the radio frequency module 200 in a one-to-one correspondence, and are configured to output a radio frequency signal of the MHB through one or more of the four signal output ports 150.

For example, the second switch matrix 260 is a 2×2 switch array, that is, DPDT. One input terminal of the second switch matrix 260 is coupled to an output terminal of the second LNA 210-1. When the second LNA 210 is switched to the first impedance state, the second switch matrix 260 may receive a radio frequency signal of the LB outputted by the second LNA 210-1. Another input terminal of the second switch matrix 260 is coupled to the output terminal of the third LNA 310-1, and is configured to receive a radio frequency signal of the LB outputted by the third LNA 310-1. Further, two output terminals of the second switch matrix 260 are respectively coupled to two signal output ports 250 of the LB of the radio frequency module 200, and are configured to output a radio frequency signal of the LB through one or more of the two signal output ports 250.

In the radio frequency module 200 shown in FIG. 10, when the second LNA 210-1 is switched to the first impedance state, a MIMO receiving requirement or a 2Inter-band CA receiving requirement in an LB scenario may be met. When the second LNA 210-1 is switched to the second impedance state, 3Inter-band CA accompanying a MIMO receiving requirement of one frequency band therein in an MHB scenario may be met.

For example, for the MHB scenario, in an example in which CA of the B1 band, the B3 band, and the B41 band accompanies MIMO receiving of the B41 band, the first LNA 110-2 may be configured to receive a radio frequency signal of the B1 band, the first LNA 110-3 may be configured to receive a radio frequency signal of the B3 band, the first LNA 110-1 may be configured to receive a radio frequency signal of the B41 band, and the second LNA 210-1 may be switched to the second impedance state, and is configured to receive a MIMO signal of the B41 band.

For example, for an LB scenario, MIMO receiving in the B28 band is used as an example. The third LNA 310-1 may be configured to receive a radio frequency signal of the B28 band, and the second LNA 210-1 may be switched to a first impedance state, and is configured to receive a MIMO signal of the B28 band.

It can be learned that, compared with the radio frequency module shown in FIG. 5, the radio frequency module shown in FIG. 10 reduces one LNA of the MHB in a case in which 3Inter-band CA accompanying a MIMO receiving requirement of one frequency band therein in an MHB scenario and a MIMO receiving requirement in an LB scenario are met. In addition, in the MHB scenario, the second LNA 210 may be reused as an LNA of the MHB in a manner of switching the impedance state, and is not idle. Therefore, utilization of the LNA is higher.

It can be learned that, according to the radio frequency module 200 provided in this embodiment of this application, utilization of the LNA is higher. In a case in which a maximum use scenario is unchanged, a quantity of required LNAs is smaller, and a chip area of the radio frequency module 200 is smaller, so that the radio frequency module can be applied to a small-sized electronic device such as a mobile phone.

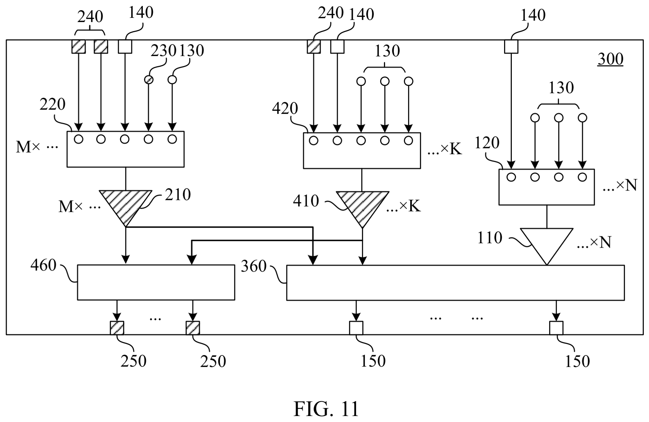

FIG. 11 is an example schematic structural diagram of a radio frequency module 300 according to an embodiment of this application.

As shown in FIG. 11, in an embodiment, based on the structure shown in FIG. 6, the radio frequency module 300 may further include:

K fourth LNAs 410 coupled between the signal input port and the signal output port, where K is a positive integer.

In some embodiments, the fourth LNA 410 is configured as the second impedance state, and the second impedance state may be a default impedance state of the fourth LNA 410. When the fourth LNA 410 is in the second impedance state, the fourth LNA 410 may amplify and output a radio frequency signal of a first frequency band.

In some embodiments, the fourth LNA 410 includes a second impedance adjustment network, and the second impedance adjustment network is configured to adjust an input impedance and/or an output impedance of the fourth LNA 410, so that the fourth LNA 410 is switched from the second impedance state to the first impedance state. The first impedance state may be an impedance state reused by the fourth LNA 410. When the fourth LNA 410 is switched to the first impedance state, the fourth LNA 410 may amplify and output a radio frequency signal of a second frequency band.

It should be noted herein that the second impedance adjustment network and the first impedance adjustment network may be the same impedance adjustment network, or may be different impedance adjustment networks. Correspondingly, the fourth LNA 410 and the second LNA 210 may be the same LNA, or may be different LNAs. When the fourth LNA 410 and the second LNA 210 are the same LNA, the fourth LNA 410 may be configured as the second impedance state by default, and the second LNA 210 may be configured as the first impedance state by default by adjusting a state of the impedance adjustment network.

For example, when in the second impedance state, the fourth LNA 410 amplifies and outputs the radio frequency signal of the MHB. In this case, the second impedance adjustment network may be used to switch the fourth LNA 410 from the second impedance state to the first impedance state, so that the fourth LNA 410 is switched to amplifying and outputting a radio frequency signal of the LB. For another example, when the fourth LNA 410 is in the first impedance state, the second impedance adjustment network may be used to switch the fourth LNA 410 from the first impedance state to the second impedance state, so that the fourth LNA 410 amplifies and outputs a radio frequency signal of the MHB.

In some embodiments, an input terminal of each fourth LNA 410 may be coupled to one or more signal input ports of the first frequency band and one or more signal input port of the second frequency band of the radio frequency module by using an SPxT switch 420. The signal input port of the first frequency band may be an internal input port 130 of the first frequency band and/or an auxiliary input port 140 of the first frequency band, and the signal input port of the second frequency band may be an internal input port 230 of the second frequency band and/or an auxiliary input port 240 of the second frequency band. In this way, by switching the SPxT switch 420, the input terminal of the fourth LNA 410 is conducted to any one of the internal input port 230, the internal input port 130, the auxiliary input port 240, or the auxiliary input port 140, so as to receive a radio frequency signal from a corresponding port.

It may be understood that, based on the structure shown in FIG. 6, if the fourth LNA 410 is added, a connection relationship between the switch matrix and each LNA changes, and specifications of the switch matrix may also change. For ease of describing this change, in the structure shown in FIG. 11, the first switch matrix 160, that is, the switch matrix of the MHB band, is expressed as a third switch matrix 360. The third switch matrix 360 includes C input terminals and at least one output terminal, C is a positive integer, and C=N+M+K. A quantity of input terminals of the third switch matrix 360 is equal to a sum of a quantity of first LNAs 110, a quantity of second LNAs 210, and a quantity of fourth LNAs 410, and a quantity of output terminals may be 4, 6, or another quantity, and may be the same as or different from the quantity of input terminals, which is not specifically limited herein.

It may be understood that when A and C are the same, the first switch matrix 160 and the third switch matrix 360 are the same switch matrix.

For example, if the quantity of first LNAs 110 is 2, the quantity of second LNAs 210 is 1, and the quantity of fourth LNAs 410 is 1, that is, N=2, M=1, and K=1, the third switch matrix 360 may be a $4\times4$ switch array. If the quantity of first LNAs 110 is 3, the quantity of second LNAs 210 is 1, and the quantity of fourth LNAs 410 is 1, that is, N=3, M=1, and K=1, the third switch matrix 360 may be a 5×4 switch array.

N input terminals of the third switch matrix 360 are coupled in a one-to-one correspondence to output terminals of the N first LNAs 110, and are configured to receive radio frequency signals of the first frequency bands outputted by the N first LNAs 110. M input terminals of the third switch matrix 360 are in a one-to-one correspondence with output terminals of the M second LNAs 210. When the second LNA 210 is switched to the second impedance state, the output terminal of the second LNA 210 is coupled to an input terminal of a third switch matrix 360 corresponding thereto. In this way, the M input terminals of the third switch matrix 360 may receive radio frequency signals of the first frequency band outputted by the M second LNAs 210. K input terminals of the third switch matrix 360 are in a one-to-one correspondence with output terminals of the K fourth LNAs 410. When the fourth LNA 410 is switched to the second impedance state, the output terminal of the fourth LNA 410 is coupled to an input terminal of a third switch matrix 360 corresponding thereto. In this way, the K input terminals of the third switch matrix 360 may receive radio frequency signals of the first frequency band outputted by the K fourth LNAs 410.

For example, if the quantity of first LNAs 110 is 2, the quantity of second LNAs 210 is 1, and the quantity of fourth LNAs 410 is 1, that is, N=3, M=1, and K=1, output terminals of the two first LNAs 110 may be coupled to two input terminals of the third switch matrix 360 in a one-to-one correspondence, an output terminal of the second LNA 210 may be coupled to another input terminal of the third switch matrix 360, and an output terminal of the fourth LNA 410 may be coupled to the remaining input terminal of the third switch matrix 360.

Further, at least one output terminal of the third switch matrix 360 is coupled to at least one signal output port 150 in a one-to-one correspondence, and is configured to output a radio frequency signal of the first frequency band through the at least one signal output port 150.

As shown in FIG. 11, in an embodiment, based on the structure shown in FIG. 6, the radio frequency module may further include a fourth switch matrix 460. The fourth switch matrix 460 includes D input terminals and at least one output terminal, D is a positive integer, and D=M+K. A quantity of input terminals of the fourth switch matrix 460 is equal to a sum of a quantity of second LNAs 210 and a quantity of fourth LNAs 410, and a quantity of output terminals may be 2, 4, or another quantity, and may be the same as or different from the quantity of input terminals, which is not specifically limited herein.

For example, if the quantity of second LNAs 210 is 1, the quantity of fourth LNAs 410 is 1, that is, M=1 and K=1. In this case, the fourth switch matrix 460 may be a 2×2 switch array, that is, DPDT. If the quantity of second LNAs 210 is 1, and the quantity of fourth LNAs 410 is 2, that is, M=1 and K=2, the fourth switch matrix 460 may be a 3×2 switch array.

M input terminals of the fourth switch matrix 460 are in a one-to-one correspondence with output terminals of the M second LNAs 210. When the second LNA 210 is switched to the first impedance state, the second LNA 210 is coupled to an input terminal of a fourth switch matrix 460 corresponding thereto. In this way, the fourth switch matrix 460 receives a radio frequency signal of the second frequency band outputted by the second LNA 210. In addition, K input terminals of the fourth switch matrix 460 are in a one-to-one correspondence with output terminals of the K fourth LNAs 410. When the fourth LNA 410 is switched to the first impedance state, the fourth LNA 410 is coupled to an input terminal of a fourth switch matrix 460 corresponding thereto. In this way, the fourth switch matrix 460 may receive a radio frequency signal of the second frequency band outputted by the fourth LNA 410.

For example, if the quantity of second LNAs 210 is 1, the quantity of fourth LNAs 410 is 1, that is, M=1 and K=1. In this case, an output terminal of one second LNA 210 is coupled to one input terminal of the fourth switch matrix 460, and an output terminal of one fourth LNA 410 is coupled to another input terminal of the fourth switch matrix 460.

Further, at least one output terminal of the fourth switch matrix 460 is coupled to at least one signal output port 250 in a one-to-one correspondence, and is configured to output a radio frequency signal of the second frequency band through the at least one signal output port 250.

For content not specifically expanded in FIG. 11, refer to FIG. 6 for implementation. Details are not described herein again.

According to the radio frequency module 300 provided in this embodiment of this application, the second LNA operates on the second frequency band by default, and may be reused to the first frequency band, and the fourth LNA operates on the first frequency band by default, and may be reused to the second frequency band. In this way, in a scenario of the first frequency band, the second LNA may be reused, so as to increase utilization of the LNA. In a scenario of the second frequency band, the fourth LNA may be reused, so as to increase utilization of the LNA. Therefore, when a maximum use scenario of the radio frequency module is unchanged, a quantity of required LNAs is smaller, and a chip area is smaller.

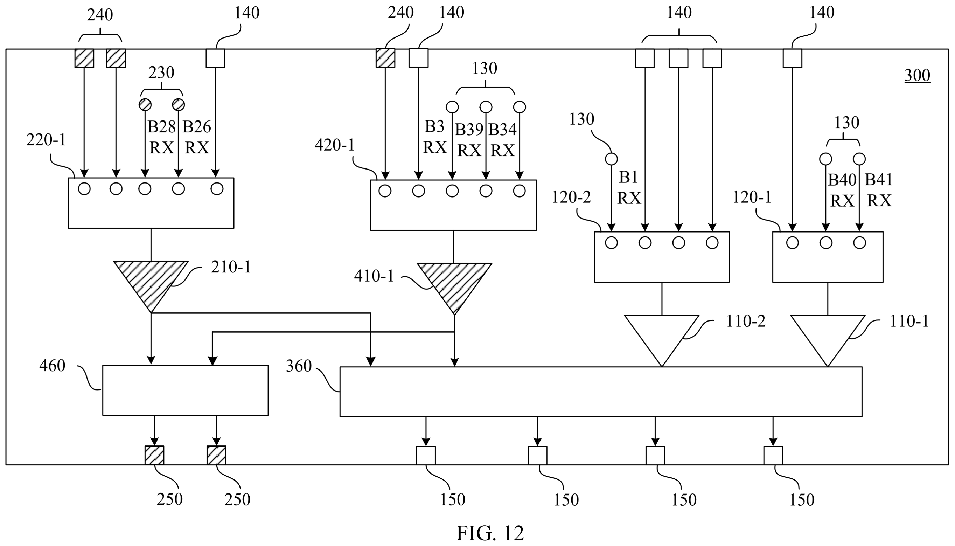

FIG. 12 is a schematic diagram of a preferred implementation of a radio frequency module 300 according to an embodiment of this application.

With reference to FIG. 12, the following exemplarily describes a preferred implementation of the radio frequency module shown in FIG. 11 with two first LNAs 110, one second LNA 210, and one fourth LNA 410.

For example, as shown in FIG. 12, the radio frequency module 300 may include a first LNA 110-1, a first LNA 110-2, a second LNA 210-1, and a fourth LNA 410-1 that are coupled between a signal input port and a signal output port.

For example, an SP3T switch 120-1 is disposed on an input terminal of the first LNA 110-1. One input terminal of the SP3T switch 120-1 is coupled to one auxiliary input port 140 of an MHB of the radio frequency module 300. The other two input terminals of the SP3T switch 120-1 are coupled to internal input ports 130 of the MHB of the radio frequency module 300 in a one-to-one correspondence, and are respectively configured to receive a radio frequency signal of the B40 band and a radio frequency signal of the B41 band.

For example, an SP4T switch 120-2 is disposed on an input terminal of the first LNA 110-2. Three input terminals of the SP4T switch 120-2 are coupled to three auxiliary input ports 140 of the MHB of the radio frequency module 300 in a one-to-one correspondence. The other input terminal of the SP4T switch is coupled to an internal input port 130 of the MHB of the radio frequency module 300, and is configured to receive a radio frequency signal of the B1 band.

For example, an SP5T switch 220-1 is disposed on an input terminal of the second LNA 210-1. Two input terminals of the SP5T switch 220-1 are coupled to two auxiliary input ports 240 of the LB of the frequency module 300 in a one-to-one correspondence, and are configured to receive radio frequency signals of the LB. Another two input terminals of the SP5T switch 220-1 are coupled to two internal input ports 230 of the LB of the frequency module 300 in a one-to-one correspondence, and are respectively configured to receive a radio frequency signal of the B26 band and a radio frequency signal of the B28 band. The remaining one input terminal of the SP5T switch 220-1 is coupled to one auxiliary input port 140 of the MHB of the module 300, and is configured to receive a radio frequency signal of the MHB.

For example, an SP5T switch 420-1 is disposed on an input terminal of the fourth LNA 410. One input terminal of the SP5T switch 420-1 is coupled to one auxiliary input port 240 of the LB of the radio frequency module 300. Another input terminal of the SP5T switch 420-1 is coupled to one auxiliary input port 140 of the MHB of the radio frequency module 300. The other three input terminals of the SP5T switch 420-1 are coupled to three internal input ports 130 of the MHB of the radio frequency module 300 in a one-to-one correspondence, and are respectively configured to receive radio frequency signals of the B3 band, the B39 band, and the B34 band.

For example, the third switch matrix 360 is a 4×4 switch matrix. Two input terminals of the third switch matrix 360 are respectively coupled to output terminals of the two first LNA 110, and are configured to receive radio frequency signals of the MHB outputted by the two first LNA 110. Another input terminal of the third switch matrix 360 is coupled to an output terminal of the second LNA 210. In this way, when the second LNA 210 is switched to the second impedance state, the third switch matrix 360 may receive a radio frequency signal of the MHB outputted by the second LNA 210. The remaining one input terminal of the third switch matrix 360 is coupled to an output terminal of the fourth LNA 410. In this way, when the fourth LNA 410 is switched to the second impedance state, the third switch matrix 360 may receive a radio frequency signal of the MHB outputted by the fourth LNA 410.

Further, four output terminals of the third switch matrix 360 are coupled to four signal output ports 150 of the MHB of the radio frequency module 300 in a one-to-one correspondence, and are configured to output a radio frequency signal of the MHB through one or more of the four signal output ports 150.

For example, the fourth switch matrix 460 is a 2×2 switch array. One input terminal of the fourth switch matrix 460 is coupled to an output terminal of the second LNA 210. When the second LNA 210 is switched to the first impedance state, the fourth switch matrix 460 may receive a radio frequency signal of the LB outputted by the second LNA 210. The other input terminal of the fourth switch matrix 460 is coupled to an output terminal of the fourth LNA 410. When the fourth LNA 410 is switched to the first impedance state, the fourth switch matrix 460 may receive a radio frequency signal of the LB outputted by the fourth LNA 410.

Further, output terminals of the fourth switch matrix 460 are respectively coupled to two signal output ports 250 of the LB of the radio frequency module 300, and are configured to output a radio frequency signal of the LB through one or more of the two signal output ports 250.

In the radio frequency module shown in FIG. 12, when both the second LNA 210-1 and the fourth LNA 410-1 are switched to the first impedance state, a MIMO receiving requirement or a 2Inter-band CA receiving requirement in an LB scenario may be met.

For example, for the LB scenario, ENDC receiving in the B20+N28 bands is used as an example. The second LNA 210-1 is switched to the first impedance state, and may be configured to receive a radio frequency signal of the B20 band, and the fourth LNA 410-1 is switched to the first impedance state, and may be configured to receive a radio frequency signal of the N28 band, so as to implement ENDC receiving of the B20 band and the N28 band.

For example, for the LB scenario, MIMO receiving in the B28 band is used as an example. The second LNA 210-1 is switched to the first impedance state, and may be configured to receive a radio frequency signal of the B28 band, and the fourth LNA 410-1 is switched to the first impedance state, and may be configured to receive a MIMO signal of the B28 band, so as to implement MIMO receiving of the B28 band.

In addition, when both the second LNA 210-1 and the fourth LNA 410-1 are switched to the second impedance state, 3Inter-band CA accompanying a MIMO receiving requirement of one frequency band therein in an MHB scenario may be met.

For example, for the MHB scenario, in an example in which CA of the B1 band, the B3 band, and the B41 band accompanies MIMO receiving of the B41 band, the first LNA 110-2 may be configured to receive a radio frequency signal of the B1 band, the first LNA 110-1 may be configured to receive a radio frequency signal of the B41 band, the fourth LNA 410-1 is switched to the second impedance state and may be configured to receive a radio frequency signal of the B3 band, and the second LNA 210-1 is switched to the second impedance state and may be configured to receive a MIMO signal of the B41 band.

It can be learned that the radio frequency module 300 shown in FIG. 12 reduces two LNAs compared with the radio frequency module 50 shown in FIG. 5, and reduces one LNA compared with the radio frequency module 200 shown in FIG. 10, in a case in which 3Inter-band CA accompanying a MIMO receiving requirement of one frequency band therein in an MHB scenario and a MIMO receiving requirement in an LB scenario are met. In addition, in the MHB scenario, the second LNA 210-1 may be reused as an LNA of the MHB band in a manner of switching the impedance state, and is not idle. In the LB scenario, the fourth LNA 410-1 may be reused as an LNA of the LB band in a manner of switching the impedance state, and is not idle. Therefore, utilization of the LNA is higher.

It can be learned that, in the radio frequency module provided in this embodiment of this application, in a case in which the quantity of LNAs is not increased, a larger use scenario can be met, and utilization of the LNA is higher. In a case in which a same use scenario is met, a quantity of required LNAs is smaller.

An embodiment of this application further provides an LNA 500.

The LNA 500 may be used as a second LNA and a fourth LNA in a radio frequency module provided in an embodiment of this application, so as to implement switching between a plurality of impedance states, for example, a first impedance state and a second impedance state.

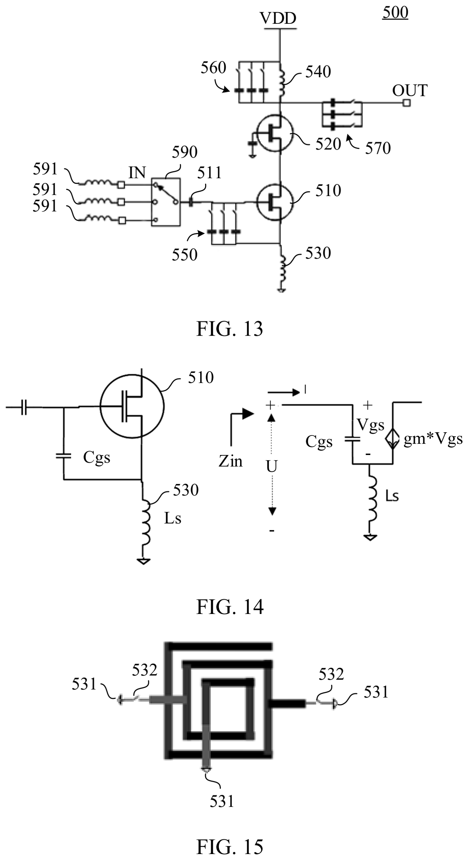

FIG. 13 is an example schematic structural diagram of an LNA 500 according to an embodiment of this application.

As shown in FIG. 13, the LNA 500 may include:

a first transistor 510, where a gate of the first transistor 510 is coupled to an input terminal of a radio frequency signal; where a DC-blocking capacitor 511 may further be disposed between the gate of the first transistor 510 and the input terminal IN of the radio frequency signal, so as to isolate a direct-current signal in a circuit; a second transistor 520, where a source of the second transistor 520 is coupled to a drain of the first transistor 510, and a gate of the second transistor 520 is coupled to a ground; a first inductor 530, where one terminal of the first inductor 530 is coupled to a source of the first transistor 510, and the other terminal thereof is coupled to the ground; where in some embodiments, an inductance value of the first inductor 530 is a fixed value; a second inductor 540, where one terminal of the second inductor 540 is coupled to a drain of the second transistor 520, and the other terminal thereof is coupled to a power supply voltage VDD; where an inductance value of the second inductor 540 is a fixed value; and

an impedance adjustment network, where the impedance network may be used as a first impedance adjustment network in the second LNA, or may be used as a second impedance adjustment network in the fourth LNA. The impedance adjustment network includes:

a first capacitor group 550, where the first capacitor group 550 is coupled between the gate and the source of the first transistor 510, and the first capacitor group 550 is configured to be switchable between a plurality of capacitance values;
where in some embodiments, the first capacitor group 550 may consist of a plurality of capacitors connected in series and/or in parallel, so that the first capacitor group 550 is switchable between a plurality of different capacitance values by changing a quantity or a combination of capacitors connected to the circuit;
in this embodiment of this application, the inductance value of the first inductor 530 is fixed, and the first capacitor group 550 is added between the gate and the source of the first transistor 510; in this way, the first inductor 530 and the first capacitor group 550 constitute a series tuning network; by adjusting the capacitance value of the first capacitor group 550, an input impedance of the LNA may be adjusted, so that the input impedance of the LNA matches different frequency bands, that is, an input loop of the LNA may resonate in different frequency bands, for example, resonate in a frequency band in the MHB or a frequency band in the LB;
a second capacitor group 560, where the second capacitor group 560 is coupled between the power supply voltage VDD and the drain of the second transistor 520 and is in parallel with the second inductor 540, and the second capacitor group 560 is configured to be switchable between a plurality of capacitance values;
where in some embodiments, the second capacitor group 560 may consist of a plurality of capacitors connected in series and/or in parallel, so that the first capacitor group 550 is switchable between a plurality of different capacitance values by changing the quantity or the combination of capacitors connected to the circuit; and

a third capacitor group 570, where the third capacitor group 570 is coupled between an output terminal OUT of the radio frequency signal and the drain of the second transistor 520, and the third capacitor group 570 is configured to be switchable between a plurality of capacitance values;

where in some embodiments, the first capacitor group 550 may consist of a plurality of capacitors connected in series and/or in parallel, so that the first capacitor group 550 is switchable between a plurality of different capacitance values by changing a quantity or a combination of capacitors connected to the circuit.

In this embodiment of this application, the inductance value of the second inductor 540 is fixed, and one second capacitor group 560 is connected to the second inductor 540 in parallel. In this way, the second inductor 540 and the second capacitor group 560 constitute a parallel resonance network. By adjusting the capacitance value of the second capacitor group 560, the parallel resonance network may be equivalent to different inductance values. In addition, the third capacitor group 570 may further form combined tuning with the parallel resonance network constituted by the second inductor 540 and the second capacitor group 560. In this way, by adjusting the capacitance values of the second capacitor group 560 and the third capacitor group 570, the output impedance of the LNA may be adjusted, so that the output impedance of the LNA matches different frequency bands. That is, an output loop of the LNA may resonate in different frequency bands, for example, resonate in a frequency band in the MHB or a frequency band in the LB.

It may be understood that, by adjusting the capacitance values of the first capacitor group 550, the second capacitor group 560, and the third capacitor group 570, the impedance state of the LNA may be changed, thereby changing a frequency band that the input impedance and the output impedance of the LNA match. For example, when the first capacitor group 550, the second capacitor group 560, and the third capacitor group 570 are switched to a first capacitance value combination, the input impedance and the output impedance of the LNA may be enabled to match the second frequency band, that is, the LNA is switched to the first impedance state. When the first capacitor group 550, the second capacitor group 560, and the third capacitor group 570 are switched to a second capacitance value combination, the input impedance and the output impedance of the LNA may be enabled to match the first frequency band, that is, the LNA is switched to the second impedance state.

It may be learned from the foregoing technical solutions that, according to the LNA provided in this embodiment of this application, by using the impedance adjustment network, the input impedance and the output impedance of the LNA may be adjusted, so that the input impedance and the output impedance of the LNA may be adjusted in a larger range, so as to match different frequency bands, and a bandwidth covered by the LNA is increased, so that the LNA can be used as an LNA of an LB, and can be reused as an LNA of an MHB. Therefore, when the LNA provided in this embodiment of this application is applied to the radio frequency module of the LMH, a quantity of LNAs can be reduced, and utilization of the LNA can be increased.

FIG. 14 is a schematic diagram of an input impedance equivalent circuit of an LNA according to an embodiment of this application.

As shown in FIG. 14, an input impedance equivalent circuit of the LNA is a small signal alternating-current equivalent circuit, and a DC-blocking capacitor on an input terminal thereof may be considered as being short-circuited and ignored. In this case, an input impedance formula of the LNA may be deduced as follows:

$$\text{Zin} = sLs + \frac{1}{sC_{gs}} + \frac{g_m}{C_{gs}} * Ls$$

Zin is an input impedance, s is complex angular frequency, $Ls$ is the inductance value of the first inductor 530, $C_{gs}$ is a parasitic gate-source capacitance of the first transistor 510, and $g_m$ is a transconductance of the component.

Generally, if input impedance matching is implemented, an imaginary part in the formula needs to be canceled, and a pure real part is reserved. That is,

$$sLs + \frac{1}{sC_{gs}} = 0$$

In a conventional LNA, the magnitude of the parasitic gate-source capacitance $C_{gs}$ of the transistor is fixed. Therefore, "the imaginary part is canceled, and the pure real part is reserved" in the foregoing formula is generally implemented by adjusting the inductance value $Ls$ of the first inductor 530. Generally, a higher frequency band matched by the LNA requires a smaller inductance value $Ls$ of the first inductor 530. A lower frequency band matched by the LNA requires a larger inductance value $Ls$ of the first inductor 530.

FIG. 15 is a schematic diagram of an inductor whose inductance value is adjustable.

As shown in FIG. 15, because a first inductor 530 is a ground inductor, an inductance value $Ls$ may be adjusted by switching a grounding point of the first inductor 530. For example, a plurality of grounding points 531 at different positions may be disposed on a conventional inductor, the grounding points 531 are grounded, and a switch 532 is added between the grounding point and the ground, so as to control a grounding state of each grounding point 531, and further, control a grounding position of the first inductor 530. Clearly, in this manner, the first inductor 530 needs to be designed according to a maximum inductance value requirement thereof, and occupies a relatively large area. In addition, adding the switch 532 may also introduce a parasitic resistance, thereby affecting a quality coefficient Q value of the first inductor 530, resulting in a poor gain and a noise coefficient of the LNA. Therefore, a conventional manner of adjusting the inductance value $Ls$ of the first inductor 530 is not an ideal choice for implementing impedance matching.

To reduce a size of the first inductor 530 and increase the gain and optimize the noise coefficient of the LNA, the inductance value $Ls$ of the first inductor 530 is set to a fixed value in this embodiment of this application. "The imaginary part is canceled, and the pure real part is reserved" in the foregoing formula is implemented in a manner of adjusting the parasitic gate-source capacitance $C_{gs}$, so as to implement input impedance matching.

In some embodiments, the inductance value $Ls$ of the first inductor 530 may be determined according to a highest frequency band that the LNA needs to match. For example, if the LNA is required to operate in the LB and the MB, the inductance value $Ls$ of the first inductor 530 may be determined according to a highest frequency band that needs to be matched in the MB. If the LNA is required to operate in the LB and the MHB, the inductance value $Ls$ of the first inductor 530 may be determined according to a highest frequency band that needs to be matched in the HB.

In specific implementation, when the capacitance value of the first capacitor group 550 is switched to 0 pF, that is, the first capacitor group 550 is bypassed, the inductance value $Ls$ of the first inductor 530 may be determined, so that when the LNA operates in a preset highest frequency band, "the imaginary part is offset, and the pure real part is reserved" in the formula, that is, the input impedance of the LNA matches the preset highest frequency band.

For example, if the LNA is required to operate in a 700 Mhz frequency band and a 940 Mhz frequency band of the LB, and a 1800 Mhz frequency band of the MB, the inductance value $Ls$ of the first inductor 530 may be determined according to an inductance value required by the 1800 Mhz frequency band.

It may be understood that, in addition to a highest frequency band, the LNA may further operate in a plurality of low frequency bands. Then, in a case in which the inductance value $Ls$ of the first inductor 530 is based on the highest frequency band that the LNA needs to match, to meet a requirement of a low frequency band, the first capacitor group 550 between the gate and the source of the first transistor 510 may be used to increase the parasitic gate-source capacitance $C_{gs}$, so as to implement "the imaginary part is canceled, and the pure real part is reserved" in the formula in the low frequency band, that is, the input impedance of the LNA matches the low frequency band.

It should be noted that different frequency bands are different for the parasitic gate-source capacitance $C_{gs}$. Therefore, to enable the input impedance of the LNA to match different low frequency bands, the first capacitor group 550 may switch between a plurality of different capacitance values, so that the parasitic gate-source capacitance $C_{gs}$ meets requirements of different frequency bands.

It may be learned from the foregoing technical solutions that, according to the LNA provided in this embodiment of this application, the first inductor 530 is determined based on the highest frequency band in which the LNA operates, which reduces the magnitude of the inductance value of the first inductor 530, and increases the Q value of the first inductor 530. In addition, the parasitic gate-source capacitance $C_{gs}$ is increased by further using the first capacitor group 550, so that the input impedance of the LNA can match the low frequency band. In this way, an operating frequency band of the LNA is wider, and can cover both the LB and the MB, or both the LB and the MHB.

As shown in FIG. 13, in some embodiments, the LNA may further include:

an SPxT switch 590, where the SPxT switch 590 includes one output terminal and a plurality of input terminals, and the output terminal of the SPxT switch 590 is coupled to the gate of the first transistor 510; where each output terminal is fixedly configured to receive a radio frequency signal of one frequency band; and
in some embodiments, when the LNA is used as a second LNA, the SPxT switch 590 may be the SPxT switch 220 corresponding to the second LNA in FIG. 6, and when the LNA is used as a fourth LNA, the SPxT switch 590 may be the SPxT switch 420 corresponding to the fourth LNA in FIG. 11; and
a plurality of matching inductors 591, where the matching inductors 591 are coupled to the plurality of input terminals of the SPxT switch 590 in a one-to-one correspondence.

In this embodiment of this application, the matching inductor 591 may constitute a series tuning network with the first inductor 530 and the first capacitor group 550, so as to implement input impedance matching. It may be understood that, compared with a conventional LNA, the LNA provided in this embodiment of this application introduces the first capacitor group 550, in a same frequency band, to implement a smaller inductance value of the matching inductor 591 required for input impedance matching, this helps reduce the size of the LNA, and helps select an inductor with a high Q value as the matching inductor 591.

It may be understood that, because frequency bands corresponding to the input terminals of the SPxT switch 590 are different, inductance values of the matching inductors 591 connected to the input terminals are also different.

For example, the SPxT switch 590 includes three input terminals, which are respectively used in the B28 band, the B8 band, and the B3 band. Therefore, the inductance values of the matching inductors 591 coupled to the three input terminals should be respectively used to enable the input impedance of the LNA to match the B28 band, the B8 band, and the B3 band.

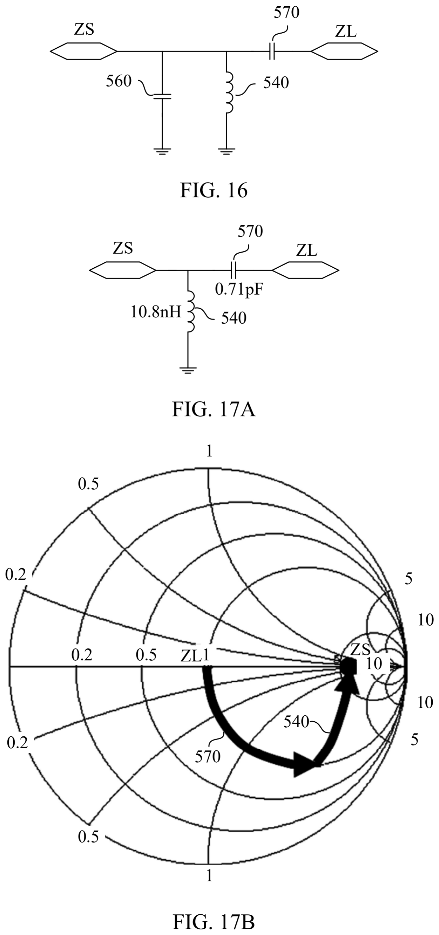

FIG. 16 is a diagram of an output terminal equivalent circuit of an LNA according to an embodiment of this application.

ZL represents a load impedance, and ZS represents a source impedance. The second inductor 540 and the second capacitor group 560 constitute a parallel resonance network. The third capacitor group 570 and the second inductor 540 and the second capacitor group 560 form combined tuning. By adjusting the capacitance values of the second capacitor group 560 and the third capacitor group 570, the output impedance of the LNA can be adjusted, so that the output impedance of the LNA matches different frequency bands.

Generally, a higher frequency band matched by the LNA requires a smaller inductance value *Ld* of the second inductor 540. A lower frequency band matched by the LNA requires a larger inductance value *Ld* of the second inductor 540. Therefore, in a conventional LNA, generally the inductance value *Ld* is adjusted to enable the output impedance of the LNA to match different frequency bands. Clearly, in this manner, the second inductor 540 needs to be designed according to a maximum inductance value requirement thereof, and occupies a relatively large area.

To reduce a size of the second inductor 540, the inductance value *Ld* of the second inductor 540 is set to a fixed value in this embodiment of this application. By adjusting the capacitance value of the second capacitor group 560, the parallel resonance network constituted by the second inductor 540 and the second capacitor group 560 is equivalent to different inductance values, so as to meet requirements of different frequency bands on the inductance value *Ld.*

In some embodiments, the inductance value *Ld* of the second inductor 540 may be determined according to a highest frequency band that the LNA needs to match. For example, if the LNA is required to operate in the LB and the MB, the inductance value *Ld* of the second inductor 540 may be determined according to a highest frequency band that needs to be matched in the MB. If the LNA is required to operate in the LB and the MHB, the inductance value *Ld* of the second inductor 540 may be determined according to a highest frequency band that needs to be matched in the HB.

In specific implementation, when the capacitance value of the second capacitor group 560 is switched to 0 pF and that of the third capacitor group 570 is switched to a preset minimum capacitance value, the inductance value Ld of the second inductor 540 may be determined, so that the output impedance of the LNA matches a preset highest frequency band.

The following exemplarily describes a manner of determining the inductance value Ld by using an example in which the highest frequency band is 2 GHz.

When the capacitance value of the second capacitor group 560 is switched to 0 pF, an output terminal equivalent circuit of the LNA is shown in FIG. 17A. In this case, the third capacitor group 570 and the second inductor 540 form combined tuning. By optimizing the values of the third capacitor group 570 and the second inductor 540, proper impedance values can be matched by the source impedance ZS and the load impedance ZL in the 2 GHz frequency band.

In specific implementation, as shown in FIG. 17B, in simulation software, the source impedance ZS and the load impedance ZL may be set, and simulation is performed by using the simulation software, to obtain the values of the third capacitor group 570 and the second inductor 540 that enable the source impedance ZS to match the load impedance ZL. As can be seen from an impedance circle shown in FIG. 17B, the second inductor 540 cancels the imaginary part of the impedance generated by the third capacitor group 570, thereby implementing conjugate matching.

For example, as shown in FIG. 17A and FIG. 17B, in the 2 GHz frequency band, when the load impedance ZL is 50 ohms and the source impedance ZS is 300 ohms, the capacitance value of the third capacitor group 570 is 0.71 pF and the inductance value of the second inductor 540 is 10.8 nH through simulation.

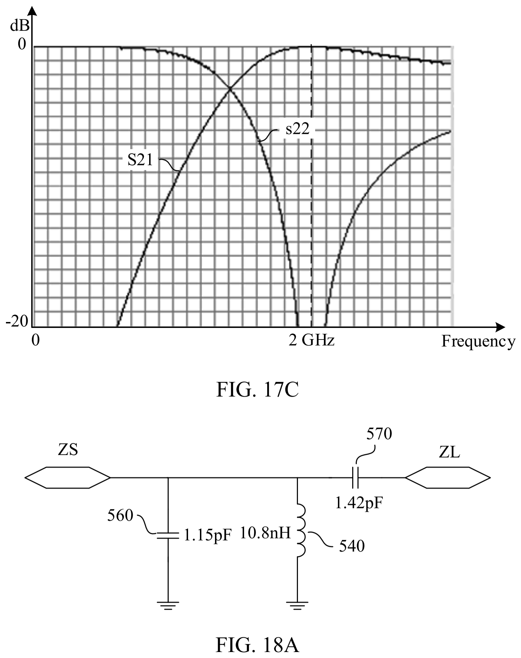

For example, as shown in FIG. 17C, when the capacitance value of the third capacitor group 570 is 0.71 pF and the inductance value of the second inductor 540 is 10.8 nH, in the 2 GHz frequency band, an output gain of the LNA is the largest (a dB value of an S21 curve is the highest), and output matching is the best (a dB value of an S22 curve is the lowest).

In this case, the inductance value of the second inductor 540 may be determined as 10.8 nH, and a minimum capacitance value that can be switched to by the third capacitor group 570 is determined as 0.71 pF.

After the inductance value of the second inductor 540 is determined, the inductance value of the second inductor 540 may be fixed in the simulation software. Through simulation, the capacitance values of the second capacitor group 560 and the third capacitor group 570 that enable the source impedance ZS to match the load impedance ZL in a lower frequency band are determined. When the capacitance value of the second capacitor group 560 is not 0 pF, an output terminal equivalent circuit of the LNA is shown in FIG. 18A.

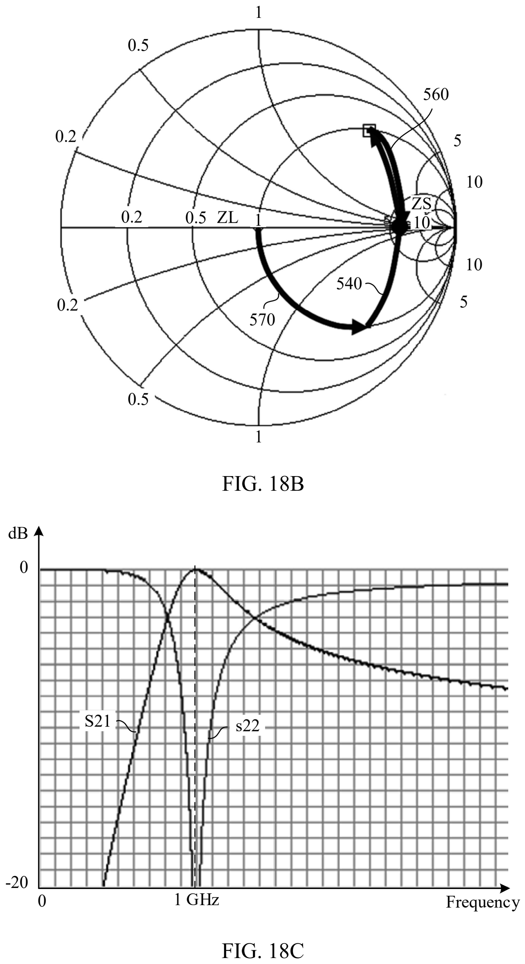

In specific implementation, as shown in FIG. 18B, in the simulation software, the source impedance ZS and the load impedance ZL may be set, the inductance value of the second inductor 540 is fixed, and simulation is performed by using ADS software, to obtain the capacitance values of the second capacitor group 560 and the third capacitor group 570. As can be seen from an impedance circle shown in FIG. 18B, imaginary parts of impedances generated by the second inductor 540, the third capacitor group 570, and the second capacitor group 560 cancel each other, thereby implementing conjugate matching.

For example, as shown in FIG. 18A and FIG. 18B, in a 1 GHz frequency band, the inductance value of the second inductor 540 is fixed to 10.8 nH. When the load impedance ZL is 50 ohms and the source impedance ZS is 300 ohms, the capacitance value of the second capacitor group 560 is 1.15 pF, and the capacitance value of the third capacitor group 570 is 1.42 pF through simulation.

For example, as shown in FIG. 18C, when the inductance value of the second inductor 540 is 10.8 nH, the capacitance value of the second capacitor group 560 is 1.15 pF, and the capacitance value of the third capacitor group 570 is 1.42 pF, an output gain of the LNA is the largest (a dB value of an S21 curve is the highest), and output matching is the best (a dB value of an S22 curve is the lowest).

It may be understood that, based on the foregoing simulation result, in a case in which the inductance value of the second inductor 540 is fixed to 10.8 nH, the second capacitor group 560 may be configured to have a level such as 0 pF or 1.15 pF, and the third capacitor group 570 may be configured to have a level such as 0.71 pF or 1.42 pF. When the input impedance of the LNA needs to be enabled to match the 2 GHz frequency band, the second capacitor group 560 may be switched to 0 pF, and the third capacitor group 570 may be switched to 0.71 pF. When the input impedance of the LNA needs to be enabled to match the 1 GHz frequency band, the second capacitor group 560 may be switched to 1.15 pF, and the third capacitor group 570 may be switched to 1.42 pF.

It may be learned from the foregoing solutions that, according to the LNA provided in this embodiment of this application, the first inductor 430 and the second inductor 540 are determined based on the highest frequency band in which the LNA operates, thereby reducing the inductance values and the sizes of the first inductor 530 and the second inductor 540. In addition, the capacitance values of the first capacitor group 550 and the second capacitor group 560 are further adjusted, so that the output impedance of the LNA can further match a low frequency band. In this way, the LNA can be switched between different operating frequency bands, and can cover both the LB and the MB, or both the LB and the MHB. In addition, the parallel resonance network constituted by the second inductor 540 and the second capacitor group 560 may be equivalent to a capacitor at a high frequency, which has a suppression effect on a high frequency higher than an operating frequency band of the LNA, and helps to suppress an out-of-band interference signal.

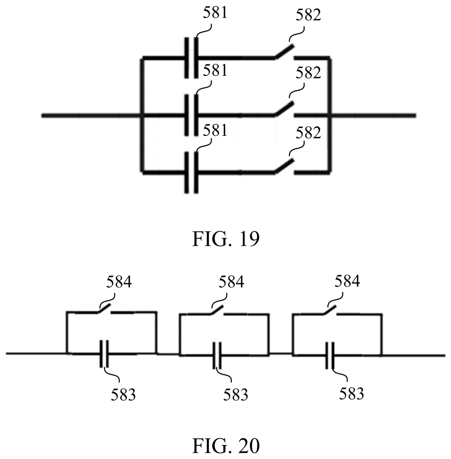

FIG. 19 is a first schematic structural diagram of a capacitor group according to an embodiment of this application.

As shown in FIG. 19, the capacitor group may include a plurality of branches disposed in parallel, and one branch capacitor 581 and one branch switch 582 are disposed in series on each branch. When the capacitor group serves as the first capacitor group 550, the plurality of branches are connected in parallel between the gate and the source of the first transistor 510. When the capacitor group serves as the second capacitor group 560, the plurality of branches are connected in parallel between the power supply voltage and the drain of the second transistor 520. When the capacitor group serves as the second capacitor group 560, the plurality of branches are connected in parallel between the output terminal of the radio frequency signal and the drain of the second transistor 520.

In this way, by controlling on and off of each branch switch 582, a quantity of capacitors parallel to a circuit can be changed, thereby changing a capacitance value of the capacitor group.

FIG. 20 is a second schematic structural diagram of a capacitor group according to an embodiment of this application.

As shown in FIG. 20, the capacitor group may include a plurality of capacitors 583 in series, and each capacitor has one bypass switch 584 in parallel. When the capacitor group serves as the first capacitor group 550, the plurality of capacitors are connected in series between the gate and the source of the first transistor 510. When the capacitor group serves as the second capacitor group 560, the plurality of capacitor groups are connected in series between the power supply voltage and the drain of the second transistor 520. When the capacitor group serves as the third capacitor group 570, the plurality of capacitor groups are connected in series between the output terminal of the radio frequency signal and the drain of the second transistor 520.

In this way, a quantity of capacitors in series in a circuit can be changed by controlling on and off of each bypass switch 584, thereby changing the capacitance value of the capacitor group.

The following uses the capacitor group shown in FIG. 19 as an example to exemplarily describe a determining process of the inductance value Ls of the first inductor 530, the inductance value Ld of the second inductor 540, and the capacitance values C1, C2, and C3 in each capacitor group in the LNA.

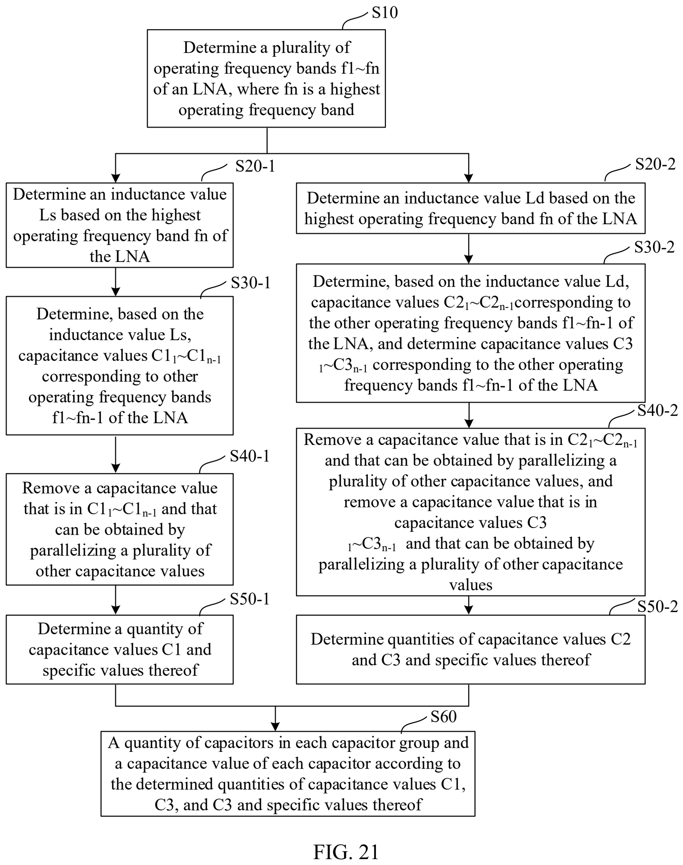

As shown in FIG. 21, the process may include:
Step S10: Determine a plurality of operating frequency bands f1~fn of an LNA, where fn is a highest operating frequency band.

For example, a plurality of operating frequency bands of the LNA may be determined according to an actual requirement, for example, f1, f2...fn-1, and fn, where f1<f2<...<fn-1<fn, f1 may be, for example, a frequency band in an LB, and fn may be, for example, a frequency band in an MHB.

Step S20-1: Determine an inductance value Ls based on the highest operating frequency band fn of the LNA.

Step S30-1: Determine, based on the inductance value Ls, capacitance values $C1_i \sim C1_{n-1}$ corresponding to other operating frequency bands f1~fn-1 of the LNA.

$C1_i \sim C1_{n-1}$ are capacitance values corresponding to the first capacitor group 550 in the other operating frequency bands f1~fn-1.

For example, the capacitance $C1_i$ corresponding to f1 may be determined, the capacitance value $C1_2$ corresponding to f2 may be determined, ..., and the capacitance value $C1_{N-1}$ corresponding to fn-1 may be determined.

Step S40-1: Remove a capacitance value that is in $C1_1 \sim C1_{n-1}$ and that can be obtained by parallelizing a plurality of other capacitance values.

For example, it is assumed that f1~fn include five bands B71, B8, B3, B40, and B41. If a capacitance value C1 corresponding to the B71 band is 2.5 pF, a capacitance value C1 corresponding to the B8 band is 2.0 pF, a capacitance value C1 corresponding to the B3 band is 1.5 pF, a capacitance value C1 corresponding to the B40 band is 0.5 pF, and a capacitance value C1 corresponding to the B41 band is 0 pF. Because 2.5 pF may be obtained in parallel by using 2.0 pF+0.5 pF, the capacitance value of 2.5 pF may be removed.

Step S50-1: Determine a quantity of capacitance values C1 and specific values thereof.

For example, assuming that f1~fn include five bands B71, B8, B3, B40, and B41, in step S40-1, after one capacitance value of 2.5 pF is removed, it may be determined that there are four capacitance values C1, that is, 2.0 pF, 1.5 pF, 0.5 pF, and 0 pF.

Step S20-2: Determine an inductance value Ld based on the highest operating frequency band fn of the LNA.

Step S30-2: Determine, based on the inductance value Ld, capacitance values $C2_1 \sim C2_{n-1}$ corresponding to the other operating frequency bands f1~fn-1 of the LNA, and determine capacitance values $C3_1 \sim C3_{n-1}$ corresponding to the other operating frequency bands f1~fn-1 of the LNA.

$C2_1 \sim C2_{n-1}$ are capacitance values corresponding to the second capacitor group 560 in the other operating frequency bands f1~fn-1.

For example, the capacitance $C2_1$ corresponding to f1 may be determined, the capacitance value $C2_2$ corresponding to f2 may be determined, ..., and the capacitance value $C1_{N-1}$ corresponding to fn-1 may be determined.

$C3_1 \sim C3_{n-1}$ are capacitance values corresponding to the second capacitor group 560 in the other operating frequency bands f1~fn-1.

For example, the capacitance value $C3_1$ corresponding to f1 may be determined, the capacitance value $C3_2$ corresponding to f2 may be determined, ..., the capacitance value $C3_{n-1}$ corresponding to fn-1 may be determined, and the capacitance value $C3_n$ corresponding to fn may be determined.

Step S40-2: Remove a capacitance value that is in $C2_1 \sim C2_{n-1}$ and that can be obtained by parallelizing a plurality of other capacitance values, and remove a capacitance value that is in $C3_1 \sim C3_{n-1}$ and that can be obtained by parallelizing a plurality of other capacitance values.

For a specific simplification manner, refer to step S40-1. Details are not described herein again.

Step S50-2: Determine quantities of capacitance values C2 and C3 and specific values thereof.

Step S60: A quantity of capacitors in each capacitor group and a capacitance value of each capacitor according to the determined quantities of capacitance values C1, C3, and C3 and specific values thereof.

For example, it is assumed that in step S50-1, four capacitance values C1 are determined, which are respectively 2.0 pF, 1.5 pF, 0.5 pF, and 0 pF. In this case, it may be determined that the first capacitor group 550 includes three parallel branches, that is, includes three parallel capacitors, and capacitance values thereof are respectively 2.0 pF, 1.5 pF, and 0.5 pF. In this way, when all the three branches are off, the capacitance value of the first capacitor group 550 is C1=0 pF. When a branch in which a capacitor of 0.5 pF is located is on and the other branches are off, the capacitance value of the first capacitor group 550 is C1=0.5 pF. When a branch in which a capacitor of 1.5 pF is located is on and the other branches are off, the capacitance value of the first capacitor group 550 is C1=1.5 pF. When a branch in which a capacitor of 2.0 pF is located is on and the other branches are off, the capacitance value of the first capacitor group 550 is C1=2.0 pF. When branches in which capacitors of 2.0 pF and 0.5 pF are located are on and the other branch is off, the capacitance value of the first capacitor group 550 is C1=2.5 pF.

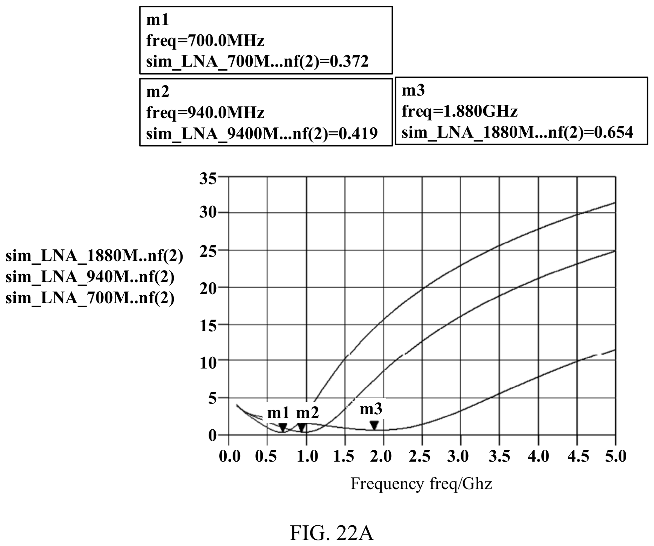

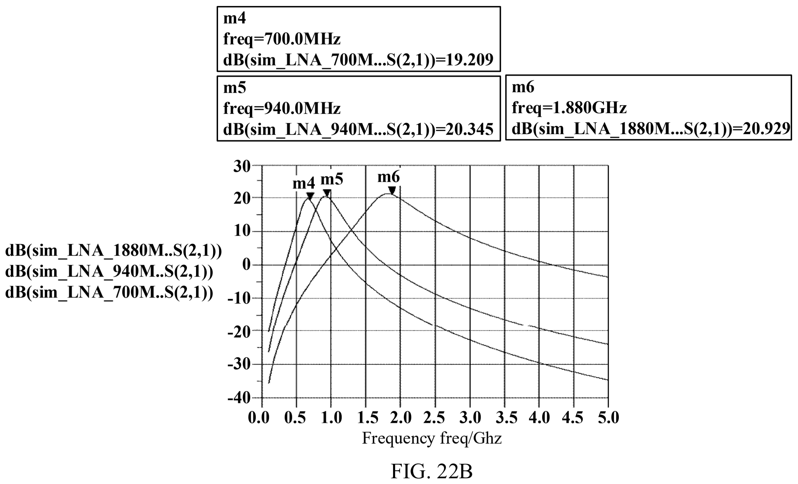

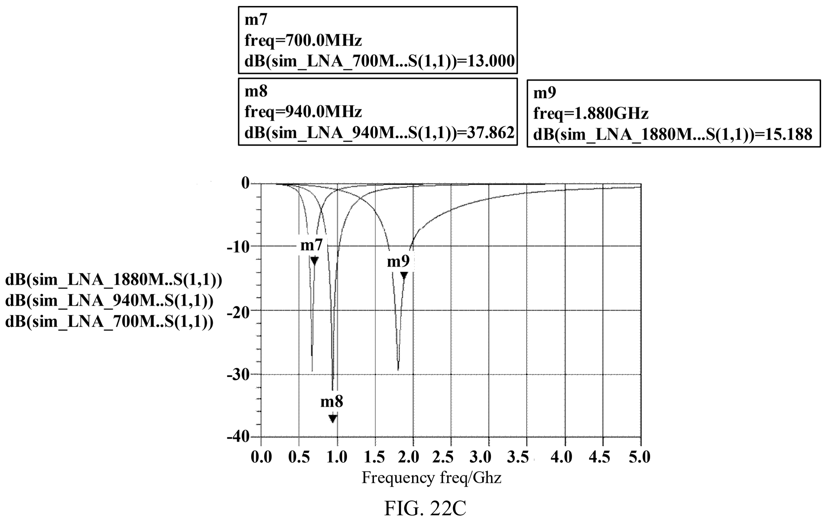

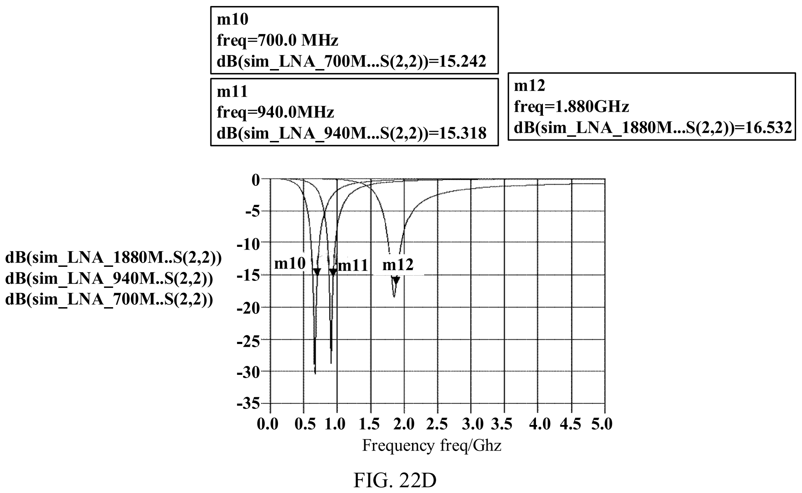

FIG. 22A, FIG. 22B, FIG. 22C, and FIG. 22D exemplarily show performance of an LNA according to an embodiment of this application. The performance is obtained through tests when the inductance value Ls and the capacitance value Ld are determined based on the 1880 MHz frequency band, and the capacitance value of each capacitor group is determined based on the 940 MHz frequency band and the 700 MHz frequency band.

FIG. 22A shows a noise coefficient m1 of an LNA operating in a 700 MHz frequency band, a noise coefficient m2 of the LNA operating in a 940 MHz frequency band, and a noise coefficient m3 of the LNA operating in a 1800 MHz frequency band according to an embodiment of this application. The lower a value of the noise coefficient, the better.

FIG. 22B is an S21 (indicating a gain/loss) curve, and shows a gain m4 of an LNA operating in a 700 MHz frequency band, a gain m5 of the LNA operating in a 940 MHz frequency band, and a gain m6 of the LNA operating in a 1800 MHz frequency band according to an embodiment of this application. The higher a value of the gain, the better.

FIG. 22C is an S11 (indicating input matching) curve, and shows an input matching degree m7 of an LNA operating in a 700 MHz frequency band, an input matching degree m8 of the LNA operating in a 940 MHz frequency band, and an input matching degree m9 of the LNA operating in a 1800 MHz frequency band according to an embodiment of this application. The lower a value of the input matching degree, the better.

FIG. 22D is an S22 (indicating output matching) curve, and shows an output matching degree m10 of an LNA operating in a 700 MHz frequency band, an output matching degree m11 of the LNA operating in a 940 MHz frequency band, and an output matching degree m12 of the LNA operating in a 1800 MHz frequency band according to an embodiment of this application. The lower a value of the output matching degree, the better.

An embodiment of this application further provides an electronic device. The electronic device may include the radio frequency module provided in the foregoing embodiments and/or the low-noise amplifier provided in the foregoing embodiments.

It is easy to understand that, on the basis of the several embodiments provided in this application, a person skilled in the art can, for example, combine, split, and reorganize the embodiments of this application to obtain other embodiments, and none of these embodiments exceeds the protection scope of this application.

The objectives, technical solutions, and beneficial effects of this application are further described in detail in the foregoing specific implementations. It should be understood that the foregoing descriptions are merely specific implementations of this application, but are not intended to limit the protection scope of this application. Any modification, equivalent replacement, or improvement made based on the technical solutions of this application shall fall within the protection scope of this application.

**Claims**

1. A radio frequency module, comprising:

    N first low-noise amplifiers coupled between a signal input port and a signal output port, wherein N is a positive integer, and an input impedance and an output impedance of the first low-noise amplifier match a first frequency band; and
    M second low-noise amplifiers coupled between the signal input port and the signal output port, wherein M is a positive integer;
    wherein the second low-noise amplifier is configured as a first impedance state, and the first impedance state comprises: an input impedance and an output impedance of the second low-noise amplifier match a second frequency band, wherein the second frequency band is lower than the first frequency band; and
    the second low-noise amplifier comprises a first impedance adjustment network, the first impedance adjustment network is configured to adjust the input impedance and the output impedance of the second low-noise amplifier, so that the second low-noise amplifier is switched from the first impedance state to a second impedance state, wherein the second impedance state comprises: the input impedance and the output impedance of the second low-noise amplifier match the first frequency band.

2. The radio frequency module according to claim 1, wherein

    the first frequency band is a middle band MB and/or a high band HB, and the second frequency band is a low band LB; or
    the first frequency band is a high band HB, and the first frequency band is a middle band MB.

3. The radio frequency module according to claim 1 or 2, further comprising:

    a first switch matrix, wherein the first switch matrix comprises A input terminals and at least one output terminal, A is a positive integer, and A=M+N;
    wherein N input terminals of the first switch matrix are coupled to output terminals of the N first low-noise amplifiers in a one-to-one correspondence; and
    the at least one output terminal of the first switch matrix is coupled to at least one first output port in a one-to-one correspondence, and the first output port is a signal output port of the first frequency band.

4. The radio frequency module according to claim 3, wherein

    M input terminals of the first switch matrix are in a one-to-one correspondence with output terminals of the M second low-noise amplifiers; and
    when the second low-noise amplifier is switched to the second impedance state, an output terminal of the second low-noise amplifier is coupled to an input terminal of the first switch matrix corresponding thereto.

5. The radio frequency module according to claim 3 or 4, wherein
    when the second low-noise amplifier is switched to the first impedance state, the second low-noise amplifier is coupled to one or more second output ports, and the second output port is a signal output port of the second frequency band.

**6.** The radio frequency module according to any one of claims 1 to 4, further comprising:

> L third low-noise amplifiers coupled between the signal input port and the signal output port, wherein L is a positive integer;
> wherein an input impedance and an output impedance of the third low-noise amplifier match the second frequency band.

**7.** The radio frequency module according to claim 6, further comprising:

> a second switch matrix, wherein the second switch matrix comprises B input terminals and at least one output terminal, B is a positive integer, and B=M+L;
> wherein L input terminals of the second switch matrix are coupled to output terminals of the L third low-noise amplifiers in a one-to-one correspondence; and
> the at least one output terminal of the second switch matrix is coupled to at least one second output port in a one-to-one correspondence, and the second output port is a signal output port of the second frequency band.

**8.** The radio frequency module according to claim 7, wherein

> M input terminals of the second switch matrix are in a one-to-one correspondence with the output terminals of the M second low-noise amplifiers; and
> when the second low-noise amplifier is switched to the first impedance state, the second low-noise amplifier is coupled to an input terminal of the second switch matrix corresponding thereto.

**9.** The radio frequency module according to claim 1, further comprising:

> K fourth low-noise amplifiers coupled between the signal input port and the signal output port, wherein K is a positive integer;
> wherein the fourth low-noise amplifier is configured as the second impedance state; and
> the fourth low-noise amplifier comprises a second impedance adjustment network, and the second impedance adjustment network is configured to adjust an input impedance and/or an output impedance of the fourth low-noise amplifier, so that the fourth low-noise amplifier is switched from the second impedance state to the first impedance state.

**10.** The radio frequency module according to claim 9, further comprising:

> a third switch matrix, wherein the third switch matrix comprises C input terminals and at least one output terminal, C is a positive integer, and C=N+M+K;
> wherein N input terminals of the third switch matrix are coupled to output terminals of the N first low-noise amplifiers in a one-to-one correspondence; and
> the at least one output terminal of the second switch matrix is coupled to at least one first output port in a one-to-one correspondence, and the first output port is a signal output port of the first frequency band.

**11.** The radio frequency module according to claim 9, wherein

> M input terminals of the third switch matrix are in a one-to-one correspondence with output terminals of the M second low-noise amplifiers; and
> when the second low-noise amplifier is switched to the second impedance state, the second low-noise amplifier is coupled to an input terminal of the third switch matrix corresponding thereto.

**12.** The radio frequency module according to claim 10 or 11, wherein

> K input terminals of the third switch matrix are in a one-to-one correspondence with output terminals of the K fourth low-noise amplifiers; and
> when the fourth low-noise amplifier is switched to the second impedance state, the second low-noise amplifier is coupled to an input terminal of the third switch matrix corresponding thereto.

**13.** The radio frequency module according to any one of claims 9 to 12, further comprising:

> a fourth switch matrix, wherein the fourth switch matrix comprises D input terminals and at least one output terminal, D is a positive integer, and D=M+K; and
> the at least one output terminal of the fourth switch matrix is coupled to at least one second output port in a one-to-one correspondence, and the second output port is a signal output port of the second frequency band.

**14.** The radio frequency module according to claim 13, wherein

> M input terminals of the fourth switch matrix are in a one-to-one correspondence with the output terminals of the M second low-noise amplifiers; and

when the second low-noise amplifier is switched to the first impedance state, the second low-noise amplifier is coupled to an input terminal of the fourth switch matrix corresponding thereto.

15. The radio frequency module according to claim 13, wherein

K input terminals of the fourth switch matrix are in a one-to-one correspondence with the output terminals of the K fourth low-noise amplifiers; and
when the fourth low-noise amplifier is switched to the first impedance state, the fourth low-noise amplifier is coupled to an input terminal of the fourth switch matrix corresponding thereto.

16. The radio frequency module according to any one of claims 1 to 8, wherein
each second low-noise amplifier is coupled to one or more internal input ports and/or auxiliary input ports of the first frequency band and coupled to one or more internal input ports and/or auxiliary input ports of the second frequency band by using a single-pole multi-throw switch.

17. The radio frequency module according to any one of claims 9 to 15, wherein:
each fourth low-noise amplifier is coupled to one or more internal input ports and/or auxiliary input ports of the first frequency band and coupled to one or more internal input ports and/or auxiliary input ports of the second frequency band by using a single-pole multi-throw switch.

18. A low-noise amplifier, comprising:

a first transistor, wherein a gate of the first transistor is coupled to an input terminal of a radio frequency signal;
a second transistor, wherein a source of the second transistor is coupled to a drain of the first transistor;
a first inductor, wherein one terminal of the first inductor is coupled to a source of the first transistor, and the other terminal thereof is coupled to a ground;
a second inductor, wherein one terminal of the second inductor is coupled to a drain of the second transistor, and the other terminal thereof is coupled to a power supply voltage; and
an impedance adjustment network, wherein the impedance adjustment network comprises:

a first capacitor group, wherein the first capacitor group is coupled between the gate and the source of the first transistor, and the first capacitor group is configured to be switchable between a plurality of capacitance values;
a second capacitor group, wherein the second capacitor group is coupled between the power supply voltage and the drain of the second transistor and is in parallel with the second inductor, and the second capacitor group is configured to be switchable between a plurality of capacitance values; and
a third capacitor group, wherein the third capacitor group is coupled between an output terminal of the radio frequency signal and the drain of the second transistor, and the third capacitor group is configured to be switchable between a plurality of capacitance values;
wherein the impedance adjustment network is configured to: enable the low-noise amplifier to be in a first impedance state and enable the low-noise amplifier to switch from the first impedance state to a second impedance state by switching capacitance values of the first capacitor group, the second capacitor group, and/or the third capacitor group; and
the first impedance state comprises: an input impedance and an output impedance of the low-noise amplifier match a second frequency band; the second impedance state comprises: the input impedance and the output impedance of the low-noise amplifier match a first frequency band; and the second frequency band is lower than the first frequency band.

19. The low-noise amplifier according to claim 18, wherein:

the first frequency band is a middle band MB and/or a high band HB, and the second frequency band is a low band LB; or
the first frequency band is a high band HB, and the first frequency band is a middle band MB.

20. The low-noise amplifier according to claim 18 or 19, wherein:
an inductance value of the first inductor is configured to: when the capacitance value of the first capacitor group is switched to 0 pF, enable the input impedance of the low-noise amplifier to match a preset highest frequency band.

21. The low-noise amplifier according to claim 20, wherein:
an inductance value of the second inductor is configured to: when the capacitance value of the second capacitor group is switched to 0 pF and the third capacitor group is switched to a preset minimum capacitance value, enable the output impedance of the low-noise amplifier to match the preset highest frequency band.

22. The low-noise amplifier according to any one of claims 18 to 21, comprising:
the first capacitor group comprises a plurality of branches connected in parallel between the gate and the source of the first transistor, and one branch capacitor and one branch switch are disposed in series on each of the branches.

23. The low-noise amplifier according to any one of claims 18 to 21, comprising:
the second capacitor group comprises a plurality of branches connected in parallel between the power supply voltage and the drain of the second transistor, and one branch capacitor and one branch switch are disposed in series on each of the branches.

24. The low-noise amplifier according to any one of claims 18 to 21, comprising:
the third capacitor group comprises a plurality of branches connected in parallel between the output terminal of the radio frequency signal and the drain of the second transistor, and one capacitor and one branch switch are disposed in series on each of the branches.

25. The low-noise amplifier according to any one of claims 18 to 21, comprising:
the first capacitor group comprises a plurality of capacitors connected in series between the gate and the source of the first transistor, and each capacitor has one bypass switch in parallel.

26. The low-noise amplifier according to any one of claims 18 to 21, comprising:
the second capacitor group comprises a plurality of capacitors connected in series between the power supply voltage and the drain of the second transistor, and each capacitor has one bypass switch in parallel.

27. The low-noise amplifier according to any one of claims 18 to 21, comprising:
the third capacitor group comprises a plurality of capacitors connected in series between the output terminal of the radio frequency signal and the drain of the second transistor, and each capacitor has one bypass switch in parallel.

28. An electronic device, comprising the radio frequency module according to any one of claims 1 to 17 and/or the low-noise amplifier according to any one of claims 18 to 27.

FIG. 1

FIG. 2

FIG. 3

FIG. 4

FIG. 5

FIG. 6

FIG. 7

EP 4 683 217 A1

FIG. 8

FIG. 9

FIG. 10

FIG. 11

FIG. 12

FIG. 13

FIG. 14

FIG. 15

ZS    570    ZL

560    540

FIG. 16

ZS    570    ZL

0.71pF

10.8nH    540

FIG. 17A

FIG. 17B

FIG. 17C

FIG. 18A

FIG. 18B

FIG. 18C

581    582

581    582

581    582

FIG. 19

584        584        584

583        583        583

FIG. 20

S10

Determine a plurality of operating frequency bands $f1 \sim fn$ of an LNA, where $fn$ is a highest operating frequency band

S20-1

Determine an inductance value $Ls$ based on the highest operating frequency band $fn$ of the LNA

S20-2

Determine an inductance value $Ld$ based on the highest operating frequency band $fn$ of the LNA

S30-1

Determine, based on the inductance value $Ls$, capacitance values $C1_1 \sim C1_{n-1}$ corresponding to other operating frequency bands $f1 \sim fn-1$ of the LNA

S30-2

Determine, based on the inductance value $Ld$, capacitance values $C2_1 \sim C2_{n-1}$ corresponding to the other operating frequency bands $f1 \sim fn-1$ of the LNA, and determine capacitance values $C3_1 \sim C3_{n-1}$ corresponding to the other operating frequency bands $f1 \sim fn-1$ of the LNA

S40-1

Remove a capacitance value that is in $C1_1 \sim C1_{n-1}$ and that can be obtained by parallelizing a plurality of other capacitance values

S40-2

Remove a capacitance value that is in $C2_1 \sim C2_{n-1}$ and that can be obtained by parallelizing a plurality of other capacitance values, and remove a capacitance value that is in capacitance values $C3_1 \sim C3_{n-1}$ and that can be obtained by parallelizing a plurality of other capacitance values

S50-1

Determine a quantity of capacitance values C1 and specific values thereof

S50-2

Determine quantities of capacitance values C2 and C3 and specific values thereof

S60

A quantity of capacitors in each capacitor group and a capacitance value of each capacitor according to the determined quantities of capacitance values C1, C3, and C3 and specific values thereof

FIG. 21

m1
freq=700.0MHz
sim_LNA_700M...nf(2)=0.372

m2
freq=940.0MHz
sim_LNA_9400M...nf(2)=0.419

m3
freq=1.880GHz
sim_LNA_1880M...nf(2)=0.654

sim_LNA_1880M..nf(2)
sim_LNA_940M..nf(2)
sim_LNA_700M..nf(2)

Frequency freq/Ghz

FIG. 22A

m4
freq=700.0MHz
dB(sim_LNA_700M...S(2,1))=19.209

m5
freq=940.0MHz
dB(sim_LNA_940M...S(2,1))=20.345

m6
freq=1.880GHz
dB(sim_LNA_1880M...S(2,1))=20.929

dB(sim_LNA_1880M..S(2,1))
dB(sim_LNA_940M..S(2,1))
dB(sim_LNA_700M..S(2,1))

Frequency freq/Ghz

FIG. 22B

m7
freq=700.0MHz
dB(sim_LNA_700M...S(1,1))=13.000

m8
freq=940.0MHz
dB(sim_LNA_940M...S(1,1))=37.862

m9
freq=1.880GHz
dB(sim_LNA_1880M...S(1,1))=15.188

dB(sim_LNA_1880M..S(1,1))
dB(sim_LNA_940M..S(1,1))
dB(sim_LNA_700M..S(1,1))

Frequency freq/Ghz

FIG. 22C

m10
freq=700.0 MHz
dB(sim_LNA_700M...S(2,2))=15.242

m11
freq=940.0MHz
dB(sim_LNA_940M...S(2,2))=15.318

m12
freq=1.880GHz
dB(sim_LNA_1880M...S(2,2))=16.532

dB(sim_LNA_1880M..S(2,2))
dB(sim_LNA_940M..S(2,2))
dB(sim_LNA_700M..S(2,2))

FIG. 22D

# INTERNATIONAL SEARCH REPORT

| International application No. |
| --- |
| **PCT/CN2024/083224** |

| A. | CLASSIFICATION OF SUBJECT MATTER |
| --- | --- |

H03F 3/189(2006.01)i; H03F 1/26(2006.01)i

According to International Patent Classification (IPC) or to both national classification and IPC

| B. | FIELDS SEARCHED |
| --- | --- |

Minimum documentation searched (classification system followed by classification symbols)

IPC: H03F

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 射频, 信号, 低噪音放大器, 阻抗, 频带, 频段, 调节, 网络, RF, signal, LNA, impedance, band, regulate, network

| C. | DOCUMENTS CONSIDERED TO BE RELEVANT | |
| --- | --- | --- |

| Category* | Citation of document, with indication, where appropriate, of the relevant passages | Relevant to claim No. |
| --- | --- | --- |
| Y | CN 112042116 A (APPLE INC.) 04 December 2020 (2020-12-04) description, paragraphs 68-93, and figures 5-13 | 1-17, 28 |
| Y | CN 105515537 A (ZTE CORP.) 20 April 2016 (2016-04-20) description, paragraphs 55-115, and figures 1-4 | 1-17, 28 |
| A | CN 112042116 A (APPLE INC.) 04 December 2020 (2020-12-04) description, paragraphs 68-93, and figures 5-13 | 18-27 |
| A | US 2023088469 A1 (SKYWORKS SOLUTIONS, INC.) 23 March 2023 (2023-03-23) entire document | 1-28 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **03 June 2024** | **07 June 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/083224**

| Patent document cited in search report | | | Publication date (day/month/year) | Patent family member(s) | | | Publication date (day/month/year) |
|---|---|---|---|---|---|---|---|
| CN | 112042116 | A | 04 December 2020 | None | | | |
| CN | 105515537 | A | 20 April 2016 | WO | 2016045449 | A1 | 31 March 2016 |
| | | | | US | 2017294884 | A1 | 12 October 2017 |
| | | | | WO | 2016045354 | A1 | 31 March 2016 |
| US | 2023088469 | A1 | 23 March 2023 | None | | | |

Form PCT/ISA/210 (patent family annex) (July 2022)

**REFERENCES CITED IN THE DESCRIPTION**

**Patent documents cited in the description**

- CN 202310512887